# EUROPEAN PATENT APPLICATION

(11) **EP 4 838 332 A1**
(43) Date of publication of application: **11.11.2026**
(21) Application number: 25816195.9
(22) Date of filing: 30.04.2025
(51) Int. Cl.: G06F 1/16

(54) **ELECTRONIC DEVICE INCLUDING GUIDE RAIL**

(30) Priority: 28.05.2024 KR 20240068982; 12.06.2024 KR 20240076293
(71) Applicant: Samsung Electronics Co., Ltd., Suwon-si, Gyeonggi-do 16677 (KR)
(72) Inventor: LEE, Ohhee, Suwon-si, Gyeonggi-do 16677 (KR); KIM, Sanghyeon, Suwon-si, Gyeonggi-do 16677 (KR); KIM, Hyelim, Suwon-si, Gyeonggi-do 16677 (KR); YOO, Minwoo, Suwon-si, Gyeonggi-do 16677 (KR); LEE, Chulhwan, Suwon-si, Gyeonggi-do 16677 (KR); LEE, Howon, Suwon-si, Gyeonggi-do 16677 (KR)
(74) Representative: Nederlandsch Octrooibureau
(86) International application number: PCT/KR2025/005854
(87) International publication number: WO 2025/249781

(57) **Abstract**

An electronic device may include a flexible display, a first housing, a second housing movably coupled to the first housing, and a support member which supports at least a portion of the flexible display and moves according to movement of the second housing. The support member may include support bars which support the rear surface of the flexible display, first guide protrusions protruding from opposite ends of each of the multiple support bars, and second guide protrusions extending from the first guide protrusions. The electronic device may include a guide rail disposed in the first housing. The guide rail may include a guide slit. The guide slit may include a linear section, a curved section extending from the linear section, a first guide slit extending from the linear section to the curved section, and a second guide slit provided in the curved section.

## Description

### [Technical Field]

The embodiments of the disclosure relate to an electronic device including a guide rail.

### [Background Art]

Electronic devices are gradually becoming slimmer and more rigid, being enhanced in design aspects, and being improved to differentiate functional elements thereof. Electronic devices are gradually evolving from a uniform rectangular shape to diverse shapes. An electronic device may have a transformable structure that is convenient to carry and enables the use of a large-screen display. The electronic device may include a rollable electronic device (e.g., a slidable electronic device) capable of varying the display area of a flexible display (e.g., a rollable display) through the support of housings that operate in a sliding manner relative to each other. A rollable electronic device having a reliable guiding structure for a flexible display may be desired.

The above-described information may be provided as related art for the purpose of helping to understand the disclosure. No claim or determination is made as to whether any of the foregoing may be applied as prior art with respect to the disclosure.

### [Disclosure of Invention]

### [Technical Problem]

An electronic device may include a rollable electronic device (e.g., a slidable electronic device) capable of inducing expansion and/or contraction of a flexible display's display area (e.g., a rollable display, expandable display, or stretchable display), depending on the operating state. The rollable electronic device may include a first housing and a second housing movably coupled to each other. For example, the first housing and the second housing may be configured to slide relative to each other and support at least a portion of the flexible display. The flexible display may be configured to have a first display area in a slide-in state and a second display area, larger than the first display area, in a slide-out state.

The rollable electronic device may include a support member (e.g., a support bar assembly, multi-bar assembly, or flexible member) that moves together with the second housing as the second housing slides a predetermined distance from the first housing and is disposed to at least partially support the rear surface of the flexible display. The support member may support the rear surface of the flexible display and include multiple support bars spaced apart from each other at a specific interval. In the slide-in state, the support member and the flexible display may be at least partially accommodated within the inner space of the first housing. The support member may be disposed such that opposite ends of each of the multiple support bars are guided by a pair of guide rails disposed on both side surfaces of the first housing. For example, each of the multiple support bars may be coupled to the first housing such that guide protrusions formed at opposite ends thereof are guided by guide slits formed in the guide rails along the sliding direction of the second housing.

Each guide slit may include a linear section and a curved section extending from the linear section. The curved section may be formed in a "U" shape, and may provide a guide structure for partially accommodating the support bars and the flexible display within the inner space of the first housing.

The guide protrusions formed on the support bars may be advantageous in supporting the flexible display as the contact area with the inner surfaces of the guide slits increases in the linear section. However, a guide protrusion formed to have a relatively large contact area may not smoothly perform a guiding operation in the curved section due to interference from the inner surface of the guide slit. Therefore, the guide protrusions may be designed considering a guide structure for smooth guiding in the curved sections of the guide slits, and such a design structure may reduce the contact area (e.g., line contact) between the guide protrusions and the inner surfaces of the guide slits in the linear sections, making it difficult to smoothly support the flexible display. Such a reduced contact area may induce deformation of the flexible display and/or the support bars when subjected to external impacts such as, for example, dropping, thereby reducing the reliability of the product.

Various embodiments of the disclosure provide an electronic device including a guide rail that may help smoothly support and guide the flexible display through a reliable support structure of the support bars.

Embodiments of the present disclosure provide an electronic device including a guide rail that may help improve impact resistance of the flexible display through expansion of the contact area between the guide protrusions of the support bars and the guide slits in straight sections.

However, the problems that the disclosure seeks to solve are not limited to the aforementioned problems, and may be expanded in various ways without departing from the spirit and scope of the disclosure.

### [Solution to Problem]

According to various embodiments, an electronic device may include a flexible display, a first housing, a second housing movably coupled to the first housing, and a support member which supports at least a portion of the flexible display and moves according to movement of the second housing. The support member may include multiple support bars which support the rear surface of the flexible display, first guide protrusions respectively protruding from opposite ends of each of the multiple support bars, and second guide protrusions respectively extending from the first guide protrusions. The electronic device may include a guide rail disposed in the first housing and including a guide slit including a linear section and a curved section extending from the linear section. The guide slit may include a first guide slit extending from the linear section to the curved section and a second guide slit provided in the curved section. Among the first guide protrusions and the second guide protrusions, in the linear section, at least the first guide protrusions may be guided through the first guide slit, and in the curved section, the second guide protrusions may be guided through the first guide slit.

### [Advantageous Effects of Invention]

In an electronic device according to example embodiments of the disclosure, through the guiding structure in which the first guide protrusions and the second guide protrusions are guided through the first guide slit in the linear section, as only the second guide protrusions are guided through the first guide slit in the curved section, the contact area between the guide protrusions of the support bars and the inner surface of the guide slit in the linear section may be increased. This increase in contact area may induce smooth support for the flexible display and may help reduce the likelihood of damage or deformation of the flexible display and/or the support bars due to external impacts such as, for example, drops.

Various effects that are directly or indirectly identified through this document may be provided.

The effects that are capable of being obtained by the disclosure are not limited to those described herein, and other effects not described herein may be clearly understood by a person ordinarily skilled in the art to which the disclosure belongs based on the following description.

### [Brief Description of Drawings]

In connection with the description of the drawings, the same or similar components may be denoted by the same or similar reference numerals.
FIG. 1 is a block diagram of an electronic device according to various embodiments of the disclosure in a network environment.
FIGS. 2A and 2B illustrate front and rear views of an electronic device according to various embodiments of the disclosure in a slide-in state.
FIGS. 3A and 3B illustrate front and rear views of the electronic device according to various embodiments of the disclosure in a slide-out state.
FIG. 4A is an exploded perspective view of the electronic device according to various embodiments of the disclosure.
FIG. 4B is a partial cross-sectional view of the flexible display taken along line 4B-4B of FIG. 4A, according to various embodiments of the disclosure.
FIG. 5A is a cross-sectional view of the electronic device according to various embodiments of the disclosure taken along line 5a-5a in FIG. 2A.
FIG. 5B is a cross-sectional view of the electronic device according to various embodiments of the disclosure taken along line 5b-5b in FIG. 3A.
FIG. 6A is a perspective view of a support bar according to various embodiments of the disclosure.
FIG. 6B is a perspective view of a portion of the support bar according to various embodiments of the disclosure.
FIG. 7A is a perspective view of a guide rail according to various embodiments of the disclosure.
FIG. 7B is a front view of the guide rail according to various embodiments of the disclosure.
FIG. 7C is a perspective view of a portion of the guide rail according to various embodiments of the disclosure.
FIG. 8 is a flowchart illustrating an assembly process of an electronic device according to various embodiments of the disclosure.
FIGS. 9A to 9E are views illustrating the assembly process of the electronic device according to various embodiments of the disclosure.
FIG. 10A is a view illustrating a state in which a support member disposed on a flexible display is coupled to guide rails, according to various embodiments of the disclosure.
FIG. 10B is a partial perspective view illustrating area 10b of FIG. 10A, according to various embodiments of the disclosure.
FIG. 10C is a partial perspective view of a guide rail, according to various embodiments of the disclosure.
FIG. 10D is a cross-sectional view of a guide rail coupled with a support member, illustrated along line 10d-10d of FIGS. 10B and 10C, according to various embodiments of the disclosure.
FIG. 10E is a cross-sectional view of the guide rail coupled with a support member, illustrated along line 10e-10e of FIGS. 10B and 10C, according to various embodiments of the disclosure.
FIG. 10F is a cross-sectional view illustrating a state in which a support member and a guide rail are coupled, taken along line 10f-10f of FIG. 10B, according to various embodiments of the disclosure.
FIG. 10G is a cross-sectional view illustrating a state in which a support member and a guide rail are coupled, taken along line 10g-10g of FIG. 10B, according to various embodiments of the disclosure.
FIG. 10H is a view illustrating the arrangement of a first guide protrusion and a second guide protrusion in the linear section, according to various embodiments of the disclosure.
FIGS. 11A and 11B are views comparing the stress applied to the flexible display during a drop impact between a guiding structure of a comparative example and a guiding structure according to various embodiments of the disclosure.
FIG. 12A is a cross-sectional view illustrating the coupling structure of a guide rail and a support bar in the linear section, according to various embodiments of the disclosure.
FIG. 12B is a cross-sectional view illustrating the coupling structure of a guide rail and a support bar in the curved section, according to various embodiments of the disclosure.
FIG. 13A is a partial perspective view of a support bar according to various embodiments of the disclosure.
FIG. 13B is a cross-sectional view illustrating a coupling structure of the support bar of FIG. 13A and a guide rail, according to various embodiments of the disclosure.
FIG. 14A is a partial perspective view of a support bar according to various embodiments of the disclosure.
FIG. 14B is a cross-sectional view illustrating a coupling structure of the support bars of FIG. 14A and a guide rail, according to various embodiments of the disclosure.
FIG. 15A is a partial perspective view of a support bar according to various embodiments of the disclosure.
FIG. 15B is a partial perspective view of a guide rail according to various embodiments of the disclosure.
FIG. 15C is a cross-sectional view of the guide rail illustrating a guiding structure of first guide protrusions and a guide slit according to various embodiments of the disclosure.
FIG. 15D is a cross-sectional view of the guide rail illustrating a guiding structure of second guide protrusions and a guide slit according to various embodiments of the disclosure.
FIG. 16A is a partial perspective view of a support bar according to various embodiments of the disclosure.
FIG. 16B is a cross-sectional view illustrating a coupling structure of the support bars in FIG. 16A and a guide rail, according to various embodiments of the disclosure.
FIG. 17A is a partial perspective view of a support bar according to various embodiments of the disclosure.
FIG. 17B is a cross-sectional view illustrating a coupling structure of the support bars in FIG. 17A and a guide rail, according to various embodiments of the disclosure.
FIGS. 18A to 18D are partial perspective views of support bars according to various embodiments of the disclosure.

### [Mode for the Invention]

Hereinafter, embodiments of the disclosure will be described in detail with reference to the accompanying drawings such that those ordinarily skilled in the art to which the disclosure pertains can easily practice them. However, the disclosure may be implemented in many different forms without being limited to those embodiments described herein. In relation to the description of the drawings, identical or similar reference symbols may be used for the same or similar components. In some aspects, in the drawings and related descriptions, descriptions of well-known functions and configurations may be omitted for clarity and brevity.

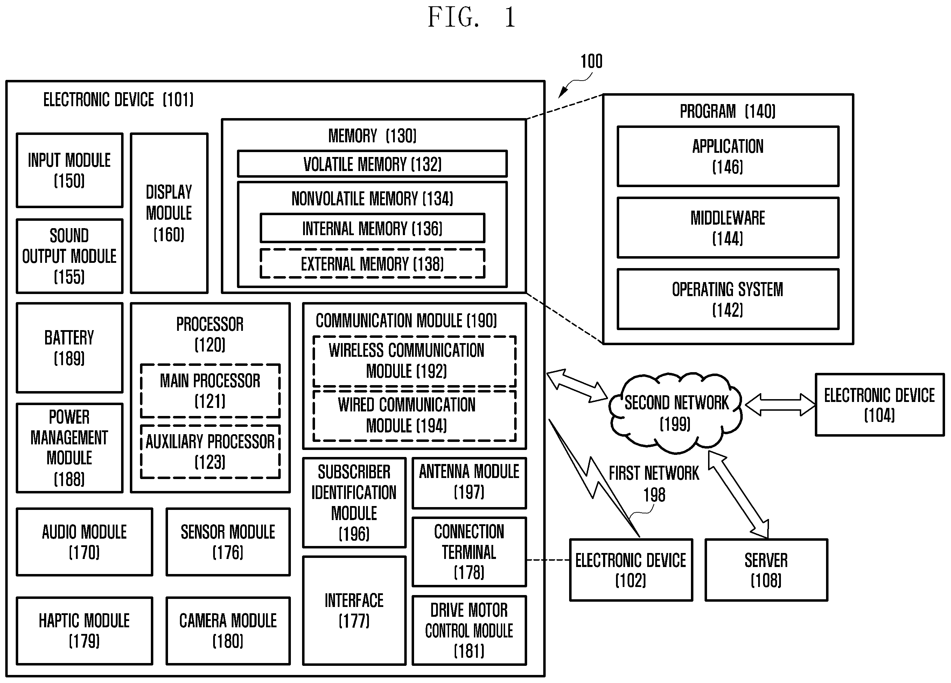

FIG. 1 is a block diagram illustrating an electronic device 101 in a network environment 100 according to various embodiments.

With reference to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. In an example in which the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, For example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, For example, a microphone, a mouse, a keyboard, a key (e.g., a button), or a digital pen (e.g., a stylus pen).

The sound output module 155 may output sound signals to the outside of the electronic device 101. The sound output module 155 may include, For example, a speaker or a receiver. The speaker may be used for general purposes, such as, for example, playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the strength of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, For example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, For example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, For example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, For example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, For example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as, for example, BluetoothTM, wireless-fidelity (Wi-Fi) direct, or infrared data association (IrDA)) or the second network 199 (e.g., a long-range communication network, such as, for example, a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as, for example, the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as, for example, the first network 198 or the second network 199, may be selected, For example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a lateral) of the printed circuit board, or adjacent to the second surface and capable of transmitting or receiving signals of the designated high-frequency band.

At least some of the above-described components may be coupled mutually and communicate signals (e.g., commands or data) therebetween via an interperipheral communication scheme (e.g., a bus, general purpose input and output (GPIO), serial peripheral interface (SPI), or mobile industry processor interface (MIPI).

According to an embodiment, commands or data may be transmitted or received between the electronic device 101 and the external electronic device 104 via the server 108 coupled with the second network 199. Each of the electronic device 102 or 104 may be a device of a same type as, or a different type, from the electronic device 101. According to an embodiment, all or some of operations to be executed at the electronic device 101 may be executed at one or more of the external electronic device 102, the external electronic device 104, or the server 108. For example, if the electronic device 101 should perform a function or a service automatically, or in response to a request from a user or another device, the electronic device101, instead of, or in addition to, executing the function or the service, may request the one or more external electronic devices to perform at least part of the function or the service. The electronic device 101 may provide the outcome, with or without further processing of the outcome, as at least part of a reply to the request. To that end, a cloud computing, distributed computing, mobile edge computing (MEC), or client-server computing technology may be used, For example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) on the basis of 5G communication technology or IoT-related technology.

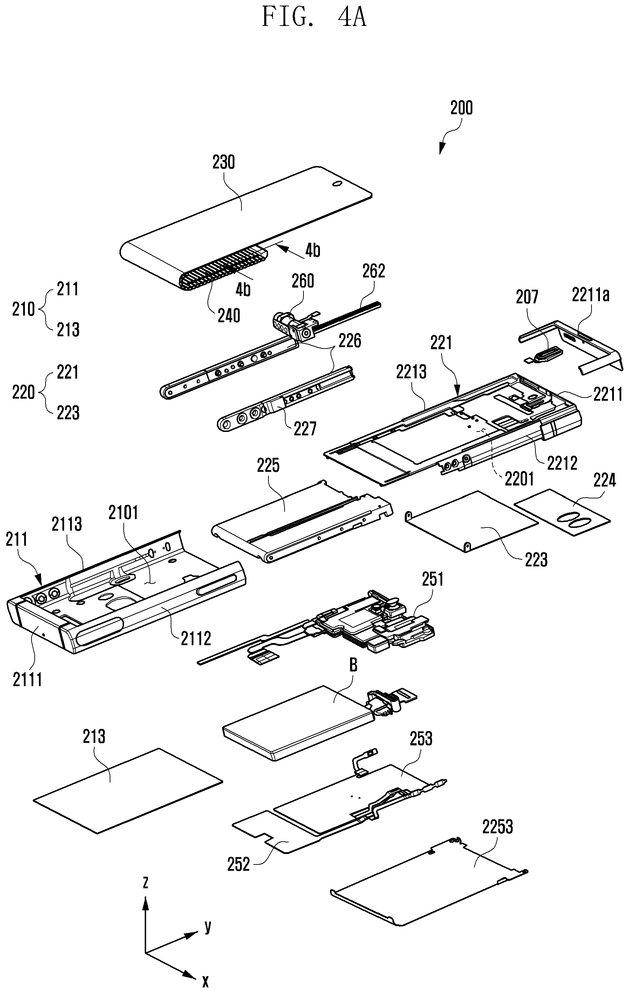

According to various embodiments, the sensor module 176 may include a movement distance detection sensor to detect a movement distance of a second housing (e.g., a second housing 220 in FIG. 4A) from a first housing (e.g., a first housing 210 in FIG. 4A) of an electronic device (e.g., an electronic device 200 of FIG. 4A). In an embodiment, through movement of the second housing 220 from the first housing 210, the sensor module 176 may detect a slide-in state being a first state, a slide-out state being a second state, or an intermediate state being a third state between the slide-in state and the slide-out state. In a certain embodiment, the processor 120 may detect the movement distance in real time through the sensor module 176 while the second housing 220 is moved from the first housing 210, and control the display module 160 to display an object in correspondence to the changing display area through a flexible display (e.g., flexible display 230 in FIG. 4A). In an embodiment, the electronic device 101 may include a drive motor control module 181 to control the operation of a drive motor (e.g., DC motor or stepping motor) (e.g., drive motor 260 in FIG. 4A) disposed inside the electronic device. In an embodiment, the drive motor control module 181 may be replaced by the processor 120.

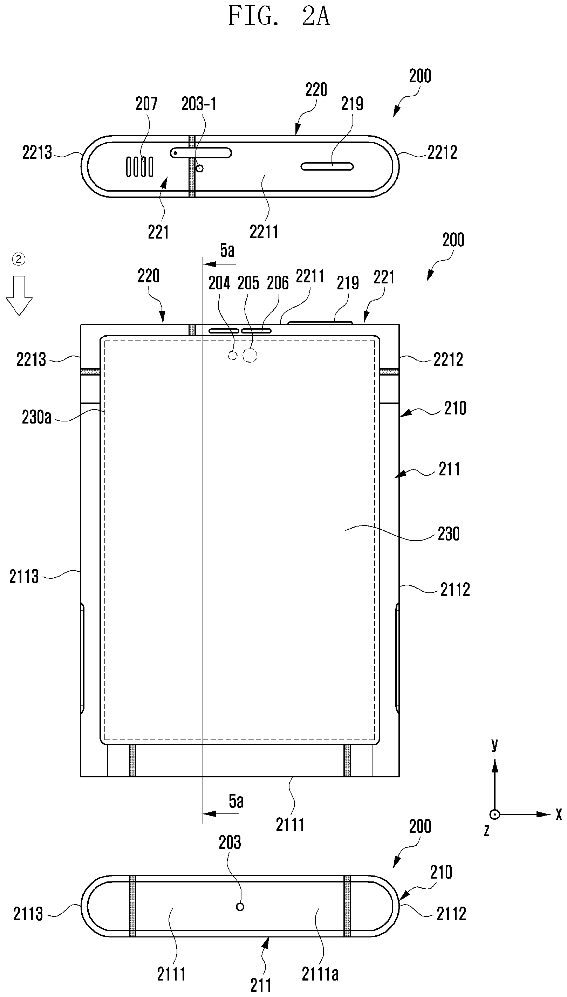

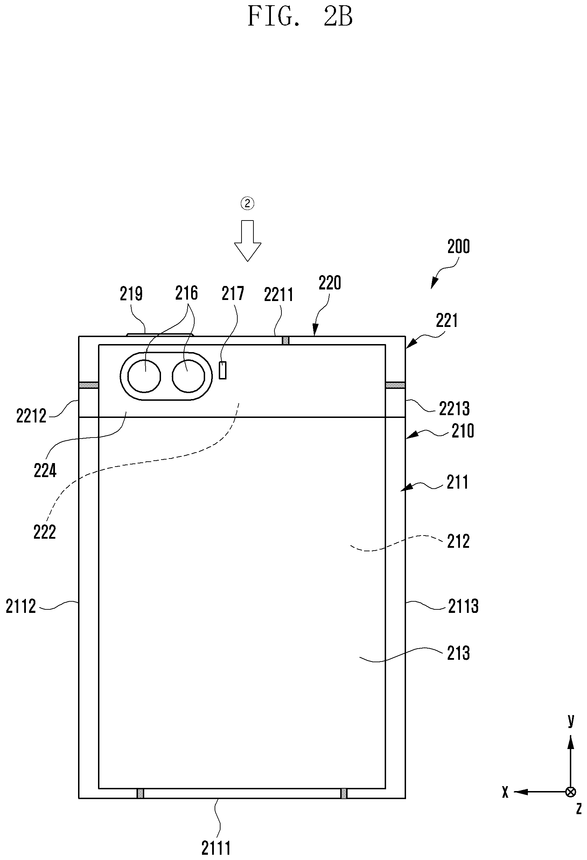

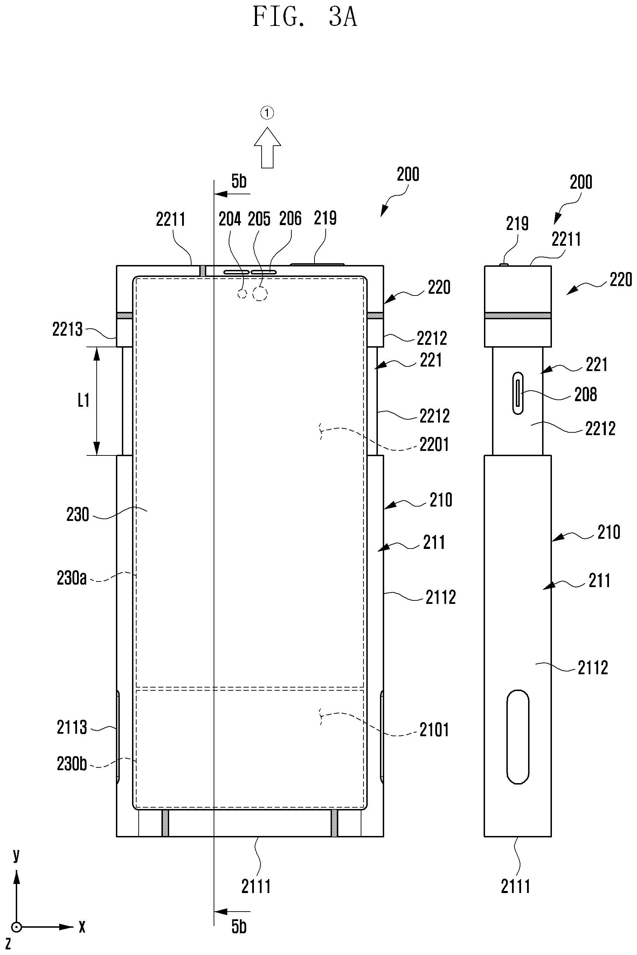

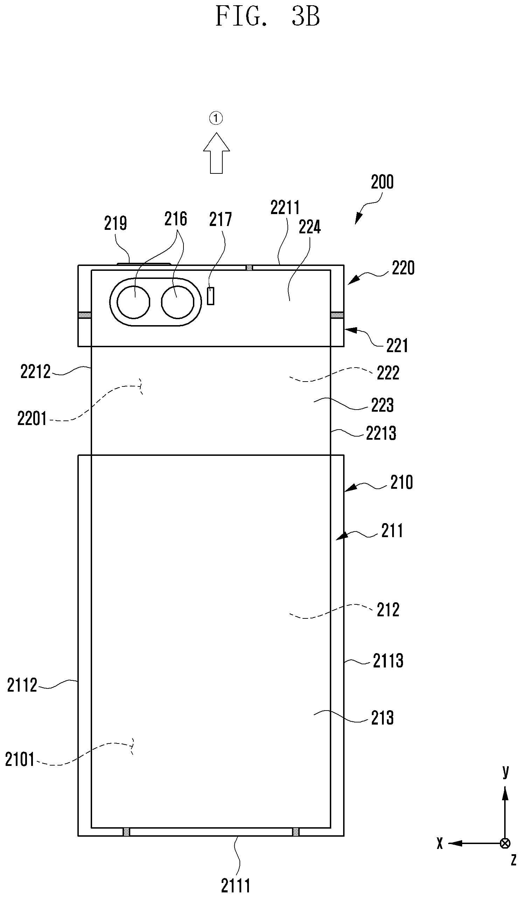

FIGS. 2A and 2B illustrate front and rear views of an electronic device according to various embodiments of the disclosure in a slide-in state. FIGS. 3A and 3B illustrate front and rear views of the electronic device according to various embodiments of the disclosure in a slide-out state.

The electronic device 200 of FIGS. 2A to 3B may be at least partially similar to the electronic device 101 of FIG. 1 or may further include other embodiments of the electronic device.

Referring to FIGS. 2A to 3B, an electronic device 200 may include a first housing 210 (e.g., a book cover or a first housing structure), a second housing 220 (e.g., a front cover or a second housing structure) slidably coupled to the first housing 210 in a predetermined direction (e.g., direction ① or direction ②) (e.g., ± y-axis direction), and a flexible display 230 (e.g., a rollable display, an expandable display, or a stretchable display) disposed to be supported by at least a portion of the first housing 210 and the second housing 220. In an embodiment, the second housing 220 may be slidably coupled to the first housing 210 such that the second housing 220 may be slid out along a first direction (direction ①) relative to the first housing 210 or slid in along a second direction (direction ②), which is opposite to the first direction (direction ①). In an embodiment, the electronic device 200 may transition to the first state, which is the slide-in state, as at least a portion of the second housing 220 is accommodated in at least a portion of a first space 2101 formed through the first housing 210. In an embodiment, the electronic device 200 may transition to the second state, which is the slide-out state, as at least a portion of the second housing 220 moves outward (e.g., in direction ①) from the first space 2101. In an embodiment, the electronic device 200 may include a support member (e.g., the support member 240 in FIG. 4A) (e.g., a bendable member, a multi-joint hinge module, a multi-bar assembly, a support bar assembly, or multiple bars), which at least partially forms the same plane as at least a portion of the second housing 220 in the slide-out state, and is at least partially accommodated in the first space 2101 of the first housing 210 in a bending manner in the slide-in state. In an embodiment, at least a portion of the flexible display 230 may be disposed to be supported by at least a portion of the second housing 220. In an embodiment, the remaining portion of the flexible display 230 may be disposed to be at least partially supported by the support member 240 (e.g., the support member 240 in FIG. 4A). In an embodiment, the support member (e.g., the support member 240 in FIG. 4A) may be disposed in a manner of being attached to the rear surface of the flexible display 230. In an embodiment, in the slide-in state, at least a portion of the flexible display 230 may be accommodated into the first space 2101 of the first housing 210 in a bending manner while being supported by the support member (e.g., the support member 240 in FIG. 4A), thereby being disposed to be invisible from the outside. In an embodiment, in the slide-out state, at least a portion of the flexible display 230 may be disposed to be visible from the outside while being supported by the support member (e.g., the support member 240 in FIG. 4A), which at least partially forms the same plane as the second housing 220.

According to various embodiments, the first housing 210 may include a first side surface member 211, and the second housing 220 may include a second side surface member 221. In an embodiment, the first side surface member 211 may include a first side surface 2111 disposed at the bottom side of the electronic device 200 and having a first length, a second side surface 2112 extending in a perpendicular direction (e.g., the y-axis direction) from one end of the first side surface 2111 and having a second length, and a third side surface 2113 extending parallel to the second side surface 2112 from the other end of the first side surface 2111 and having the second length. In an embodiment, the first side surface member 211 may be at least partially formed of a conductive member (e.g., metal). In some embodiments, the first side surface member 211 may be formed by a coupling a conductive member and a non-conductive member (e.g., polymer). In an embodiment, the first housing 210 may include a first extension member 212 extending from at least a portion of the first side surface member 211 to at least a portion of the first space 2101. In an embodiment, the first extension member 212 may be integrated with the first side surface member 211. In some embodiments, the first extension member 212 may be provided separately from the first side surface member 211 and structurally coupled to the first side surface member 211.

According to various embodiments, the second side surface member 221 may include a fourth side surface 2211 disposed at the upper side of the electronic device 200 and having a third length, a fifth side surface 2212 extending in a perpendicular direction (e.g., the -y-axis direction) from one end of the fourth side surface 2211 to correspond to the second side surface 2112 and having a fourth length, and a sixth side surface 2213 extending in a direction parallel to the fifth side surface 2212 from the other end of the fourth side surface 2211 to correspond to the third side surface 2113 and having the fourth length. In an embodiment, the second side surface member 221 may be at least partially formed of a conductive member (e.g., metal). In some embodiments, the second side surface member 221 may be formed by coupling a conductive member and a non-conductive member (e.g., polymer). In an embodiment, at least a portion of the second side surface member 221 may include a second extension member 222 extending to at least a portion of a second space 2201 in the second housing 220. In an embodiment, the second extension member 222 may be integrated with the second side surface member 221. In some embodiments, the second extension member 222 may be provided separately from the second side surface member 221 and structurally coupled to the second side surface member 221.

According to various embodiments, the second side surface 2112 and the fifth side surface 2212 may be slidably coupled to each other. In an embodiment, the third side surface 2113 and the sixth side surface 2213 may be slidably coupled to each other. In an embodiment, in the slide-in state, a portion of the fifth side surface 2212 may overlap the second side surface 2112, thereby being disposed such that the portion is substantially invisible from the outside. In an embodiment, in the slide-in state, the remaining portion of the fifth side surface 2212 may be disposed to be visible from the outside. In some embodiments, in the slide-in state, the fifth side surface 2212 may overlap the second side surface 2112, thereby being disposed such that the fifth side surface 2212 is substantially invisible from the outside. In an embodiment, in the slide-in state, a portion of the sixth side surface 2213 may overlap the third side surface 2113, thereby being disposed such that the portion is substantially invisible from the outside. In an embodiment, in the slide-in state, the remaining portion of the sixth side surface 2213 may be disposed to be visible from the outside. In some embodiments, in the slide-in state, the sixth side surface 2213 may overlap the third side surface 2113, thereby being disposed such that the sixth side surface 2213 is substantially invisible from the outside. In an embodiment, a portion of the second extension member 222 may be disposed to be visible from the outside in the slide-in state. In some embodiments, in the slide-in state, the second extension member 222 may overlap the first extension member 212, thereby being disposed such that the second extension member 222 is substantially invisible from the outside.

According to various embodiments, the first housing 210 may include a first rear surface cover 213 coupled to at least a portion of the first side surface member 211. In an embodiment, the first rear surface cover 213 may be disposed to be coupled to at least a portion of the first extension member 212. In some embodiments, the first rear cover 213 may be integrated with the first side surface member 211. In an embodiment, the first rear cover 213 may be formed of a polymer, coated or colored glass, ceramic, metal (e.g., aluminum, stainless steel (STS), or magnesium), or a combination of at least two of these materials. In some embodiments, the first rear surface cover 213 may extend to at least a portion of the first side surface member 211. In some embodiments, the first rear surface cover 213 may be omitted, and at least a portion of the first extension member 212 may replace the first rear surface cover 213.

According to various embodiments, the second housing 220 may include a second rear surface cover 223 coupled to at least a portion of the second side surface member 221. In an embodiment, the second rear surface cover 223 may be disposed by being coupled to at least a portion of the second extension member 222. In an embodiment, the second rear surface cover 223 may be integrated with the second side surface member 221. In an embodiment, the second rear surface cover 223 may be formed of polymer, coated or tinted glass, ceramic, metal (e.g., aluminum, stainless steel (STS), or magnesium), or a combination of at least two of these materials. In some embodiments, the second rear surface cover 223 may extend to at least a portion of the second side surface member 221. In some embodiments, the second rear surface cover 223 may be omitted, and at least a portion of the second extension member 222 may replace the second rear surface cover 223. In some embodiments, the second extension member 222 may be omitted, and the second rear surface cover 223 may replace the second extension member 222. In an embodiment, the second housing 220 may include a window cover 224 disposed on at least a portion of the second rear surface cover. In an embodiment, the window cover 224 may be disposed in an area exposed to the outside of the second housing 220 in the slide-in state and may be formed of a material that facilitates the detection of the external environment through at least one camera module 216 and/or sensor module 217 disposed in the inner space 2201 of the second housing 220. For example, the window cover 224 may be formed of glass and/or a polymer material in which at least an area corresponding to the camera module 216 and/or the sensor module 217 is formed to be transparent. In some embodiments, the electronic device 200 may further include a cover member 2111a disposed such that the cover member 2111a covers at least a portion of the first side surface 2111 of the first housing 210.

According to various embodiments, the flexible display 230 may include a first portion 230a (e.g., a flat portion) that is always visible from the outside, and a second portion 230b (e.g., a bendable portion or a bending portion) that extends from the first portion 230a and is at least partially bent and accommodated into the first space 2101 of the first housing 210 such that the second portion 230b is invisible from the outside in the slide-in state. In an embodiment, at least a portion of the first portion 230a may be disposed to be supported by the second housing 220, and the remaining portion of the first portion 230a and the second portion 230b may be disposed to be at least partially supported by a support member (e.g., the support member 240 in FIG. 4A). In an embodiment, in the state in which the second housing 220 is slid out along the first direction (direction ①), the second portion 230b of the flexible display 230 may form substantially the same plane as the first portion 230a while being supported by the support member (e.g., the support member 240 in FIG. 4A), and may be disposed to be visible from the outside. In an embodiment, in the state in which the second housing 220 is slid in along the second direction (direction ②), the second portion 230b of the flexible display 230 may be accommodated into the first space 2101 of the first housing 210 in a bending manner and may be disposed such that the second portion 230b is invisible from the outside. Accordingly, the display area of the flexible display 230 may be variable as the second housing 220 is moved in a sliding manner from the first housing 210 along a predetermined direction (e.g., the ±y-axis direction).

According to various embodiments, the flexible display 230 may have a first display area (e.g., an area corresponding to the first portion 230a) in the slide-in state (e.g., the first state). In an embodiment, when the second housing 220 transitions to the slide-out state (e.g., the second state), in which the second housing 220 moves by a first length L1 (e.g., a sliding stroke) relative to the first housing 210, in the flexible display 230, a second display area (e.g., an area corresponding to the second portion 230b) corresponding to the first length L1 may be additionally secured in addition to the first display area. In an example in which the flexible display 230 transitions from the slide-in state to the slide-out state, the display area may be expanded.

According to various embodiments, the electronic device 200 may include at least one of an input device (e.g., a microphone 203-1) disposed in the second space 2201 of the second housing 220, a sound output device (e.g., a phone call receiver 206 and/or a speaker 207), sensor modules 204 and 217, a camera module (e.g., the first camera module 205 or the second camera module 216), a connector port 208, a key input device 219, or an indicator (not illustrated). In an embodiment, the electronic device 200 may include another input device (e.g., the microphone 203) disposed in the first housing 210. In some embodiments, the electronic device 200 may be configured such that at least one of the described components is omitted or other components are additionally included. In some embodiments, at least one of the described components may be disposed in the first space 2101 of the first housing 210.

According to various embodiments, the input device may include a microphone 203-1. In some embodiments, the input device (e.g., the microphone 203-1) may include multiple microphones arranged to detect the direction of sound. The sound output device may include, for example, a call receiver 206 and a speaker 207. According to an embodiment, regardless of the slide-in/slide-out state, the speaker 207 may face the outside through at least one speaker hole provided in the second housing 220 at a position always exposed to the outside (e.g., in the fourth side surface 2211). In an embodiment, in the slide-out state, the connector port 208 may face the outside through a connector port hole provided in the second housing 220. In an embodiment, the connector port 208 may be covered such that the connector port 208 is invisible from the outside in the slide-in state. In some embodiments, in the slide-in state, the connector port 208 may face the outside through an opening provided in the first housing 210 to correspond to the connector port hole. In some embodiments, the call receiver 206 may include a speaker that operates without a separate speaker hole (e.g., a piezo speaker).

According to various embodiments, the sensor modules 204 and 217 may generate electrical signals or data values corresponding to an internal operating state or an external environmental state of the electronic device 200. In an embodiment, the sensor modules 204 and 217 may include, for example, a first sensor module 204 (e.g., a proximity sensor or an illuminance sensor) disposed on the front surface of the electronic device 200 and/or a second sensor module 217 (e.g., a heart rate monitoring (HRM) sensor) disposed on the rear surface of the electronic device 200. In an embodiment, the first sensor module 204 may be disposed under the flexible display 230 in the front surface of the electronic device 200. In an embodiment, the first sensor module 204 and/or the second sensor module 217 may include at least one of a proximity sensor, an illuminance sensor, a time-of-flight (TOF) sensor, an ultrasonic sensor, a fingerprint recognition sensor, a gesture sensor, a gyro sensor, an atmospheric pressure sensor, a magnetic sensor, an acceleration sensor, a grip sensor, a color sensor, an infrared (IR) sensor, a biometric sensor, a temperature sensor, or a humidity sensor.

According to various embodiments, the camera module may include a first camera module 205 disposed on the front surface of the electronic device 200 and a second camera module 216 disposed on the rear surface of the electronic device 200. In an embodiment, the electronic device 200 may include a flash (not illustrated) positioned near the second camera module 216. In an embodiment, the camera modules 205 and 216 may include one or more lenses, an image sensor, and/or an image signal processor. In an embodiment, the first camera module 205 may be disposed under the flexible display 230 and may be configured to capture a subject through a portion of an active area (e.g., a display area) of the flexible display 230.

According to various embodiments, the first camera module 205 among the camera modules and the first sensor module 204 among the sensor modules 204 and 217 may be disposed to detect the external environment through the flexible display 230. For example, the first camera module 205 or the first sensor module 204 may be disposed in the second space 2201 in the second housing 220 to be in contact with the external environment through a transmissive area or a perforated opening provided in the flexible display 230. In an embodiment, the area of the flexible display 230 that faces the first camera module 205 may be configured as the transmissive area having a predetermined transmittance, as a portion of an active area that displays content. In an embodiment, the transmissive area may have a transmittance ranging from about 5% to about 20%. The transmission area may include an area overlapping an effective area (e.g., a field of view area) of the first camera module 205 through which light imaged by an image sensor to generate an image passes. For example, the transmissive area of the flexible display 230 may include an area having a lower pixel density and/or a lower wire density than the surrounding area. For example, the described opening may replace the transmissive area. For example, some camera modules 205 may include an under-display camera (UDC). In some embodiments, some sensor modules 204 may be disposed to perform the functions thereof in the second space 2201 in the second housing 220 without being visually exposed through the flexible display 230.

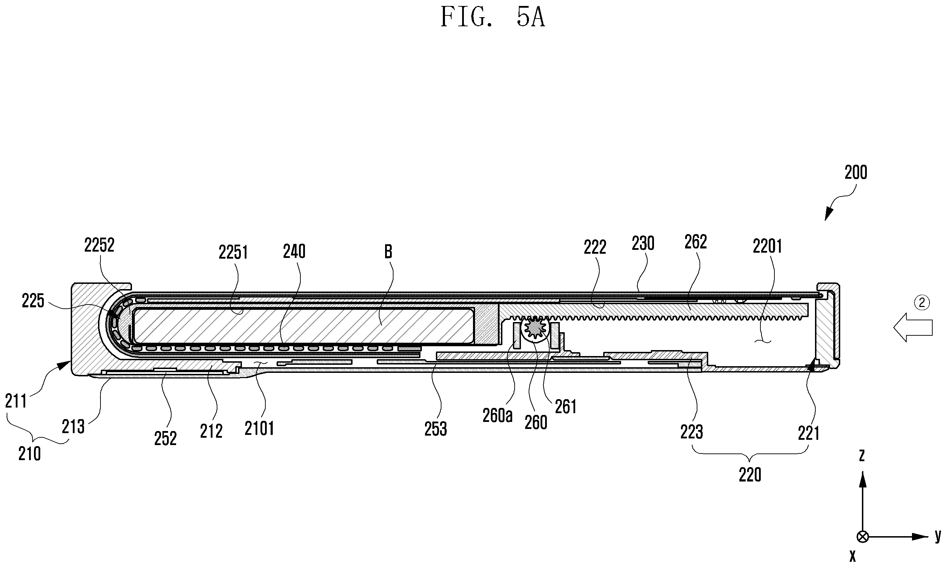

According to various embodiments, the slide-in operation and/or slide-out operation of the electronic device 200 may be automatically performed. For example, the slide-in operation and/or slide-out operation of the electronic device 200 may be performed through gear engagement between a drive motor (e.g., the drive motor 260 in FIG. 4A), which includes a pinion gear (e.g., the pinion gear 261 in FIG. 5A) disposed in the second space 2201 of the second housing 220, and a rack gear (e.g., the rack gear 262 in FIG. 5A), which is disposed in a first space 2101 of the first housing 210, extends at least partially into the second space 2201, and is engaged with the pinion gear (e.g., the pinion gear 261 of FIG. 5A). For example, the processor (e.g., the processor 120 in FIG. 1) of the electronic device 200 may drive a drive motor (e.g., the drive motor 260 of FIG. 4A) disposed inside the electronic device 200 when detecting a triggering signal for transitioning from the slide-in state to the slide-out state or from the slide-out state to the slide-in state. In an embodiment, the triggering signal may include a signal generated by the selection (e.g., touch) of an object displayed on the flexible display 230 or a signal generated by the operation (e.g., pressing) of a physical button (e.g., a key button) included in the electronic device 200.

According to various embodiments, the electronic device 200 has a structure in which the second housing 220 is slid in and/or slid out relative to the first housing 210 along the length direction of the electronic device 200 (e.g., the vertical direction) (e.g., the ±y-axis direction), but is not limited thereto. For example, the electronic device 200 may have a structure in which the second housing 220 is slid in and/or slid out relative to the first housing 210 along the width direction perpendicular to the length direction of the electronic device 200 (e.g., the horizontal direction) (e.g., the ±x-axis direction). In some embodiments, in the electronic device 200, the length of the first side surface 2111 of the first housing 210 may be greater than the length of the second side surface 2112. In this case, correspondingly, the length of the fourth side surface 2211 of the second housing 220 may also be greater than the length of the fifth side surface 2212.

FIG. 4A is an exploded perspective view of the electronic device according to various embodiments of the disclosure.

In describing the electronic device 200 of FIG. 4A, components that are substantially the same as those of the electronic device 200 of FIGS. 2A to 3B may be assigned with the same reference numerals, and a detailed description thereof may be omitted.

Referring to FIG. 4A, the electronic device 200 may include a first housing 210 including a first space 2101, a second housing 220 slidably coupled to the first housing 210 and including a second space 2201, a support member 240 (e.g., a bendable member, a support bar assembly, or a multi-bar assembly) fixed to at least a portion of the second housing 220 and at least partially accommodated in the first space 2101 in a bendable manner according to the slide-in operation, a flexible display 230 disposed to be supported by at least a portion of the support member 240 and the second housing 220, and a driver (e.g., a drive module or a drive mechanism) configured to drive the second housing 220 in the slide-in direction (e.g., the -y-axis direction) and/or the slide-out direction (e.g., the y-axis direction) from the first housing 210. In some embodiments, in the electronic device 200, the first housing 210 may be slidably coupled to the second housing 220 depending on the disposition position of the driver (e.g., the drive motor 260 and the rack gear 262). In an embodiment, the first housing 210 may include a first side surface member 211 and a first rear surface cover 213 (e.g., a first rear bracket) coupled to at least a portion of the first side surface member 211. In an embodiment, the first space 2101 may be defined by the coupling of the first side surface member 211 and the first rear surface cover 213. In an embodiment, the electronic device 200 may include a side surface cover 2211a (e.g., a dielectric cover) disposed on the fourth side surface 2211 of the second side surface member 221.

According to various embodiments, the second housing 220 may include a second side surface member 221 and a second rear surface cover 223 (e.g., a second rear bracket or a window cover) coupled to at least a portion of the second side surface member 221. In an embodiment, the second space 2201 may be defined by the coupling of the second side surface member 221 and the second rear surface cover 223. In an embodiment, the second housing 220 may be coupled to the second side surface member 221 and may include a window cover 224 forming at least a portion of the rear surface of the second housing 220.

According to various embodiments, the driver (e.g., a drive module) may be disposed in the second space 2201 and may include a drive motor 260 including a pinion gear (e.g., the pinion gear 261 in FIG. 5A) and a rack gear 262 disposed to be gear-engaged with the pinion gear 261, fixed to a support bracket 225 disposed in the first space 2101, and extending from the first space 2101 to the second space 2201. In an embodiment, the electronic device 200 may further include a speed reduction module (e.g., a reduction gear assembly) structurally coupled to the drive motor 260 and the speed reduction module may reduce the rotational speed and increase the driving force by being engaged with the drive motor 260. In an embodiment, the drive motor 260 may be disposed in the second space 2201 of the second housing 220 to be supported by at least a portion of the second side surface member 221 (e.g., the second extension member 222 in FIG. 5A). In an embodiment, the drive motor 260 may be disposed to be supported through a motor bracket (e.g., the motor bracket 260a in FIG. 5A) fixed to the second extension member 222. In some embodiments, the rack gear 262 may be guided in the sliding direction (e.g., the ±y-axis direction) through the motor bracket 260a. Accordingly, when the electronic device 200 is assembled, the pinion gear (e.g., the pinion gear 261 in FIG. 5A) may remain in a gear-engaged state with the rack gear 262, and as the pinion gear 261, which receives a driving force from the drive motor 260, moves along the rack gear 262, the second housing 220 may move in the slide-in direction (e.g., the -y-axis direction) or the slide-out direction (e.g., the y-axis direction) relative to the first housing 210.

According to various embodiments, the electronic device 200 may include a support bracket 225 fixed in the first space 2101 of the first housing 210. In an embodiment, the electronic device 200 may include a pair of guide rails 226 (e.g., a linear motion (LM) guide) that are fixed to both sides of the support bracket 225 to guide opposite ends of the support member 240 in the sliding direction while simultaneously guiding the second housing 220 in the sliding direction. In an embodiment, the support bracket 225 and the pair of guide rails 226 may be fixed to the first housing 210 through fastening members such as, for example, screws. In an embodiment, the support bracket 225 may include a battery seating portion (e.g., the battery seating portion 2251 in FIG. 5A) configured to accommodate a battery B and a support portion (e.g., the support portion 2252 in FIG. 5A) provided at one end of the battery seating portion 2251 to support the rear surface of the support member 240 that bends during the sliding operation of the second housing 220. In an embodiment, the support portion 2252 may have a curved outer surface to smoothly guide the support member 240. In an embodiment, the support bracket 225 and the guide rails 226 may be fixed in the inner space 2101 of the first housing 210 through fastening members such as, for example, screws. In an embodiment, the electronic device 200 may further include a battery cover 2253 which is coupled to the support bracket 225 and covers the mounted battery B. In some embodiments, the battery cover 2253 may be omitted. In an embodiment, the rack gear 262 may be fixed through fastening members such as, for example, screws such that the rack gear 262 extends from the outer surface of the support bracket 225 toward the second space 2201. In an embodiment, the rack gear 262 may be disposed at the center (e.g., a centrally symmetrical position) of the support bracket 225 such that the rack gear 262 traverses the center of the electronic device 200 along the sliding direction of the second housing 220 (e.g., the ±y-axis direction). This central disposition may reduce power consumption by decreasing the increase in driving resistance caused by eccentricity during the sliding operation.

According to various embodiments, the electronic device 200 may include at least one electrical component (or electronic component) disposed in the second space 2201. In an embodiment, the at least one electrical component may include a first substrate 251 (e.g., a substrate assembly or a main substrate) (e.g., stacked substrates). In some embodiments, the at least one electrical component may be disposed in the first space 2101 of the first housing 210.

According to various embodiments, the electronic device 200 may include a second substrate 252 (e.g., a sub-substrate) and an antenna member 253, which are disposed between a first extension member (e.g., first extension member 212 in FIG. 5A) and the first rear surface cover 213 in the first housing 210. In an embodiment, the second substrate 252 and the antenna member 253 may be disposed on at least a portion of the first extension member 212. In an embodiment, the second substrate 252 and the antenna member 253 may be electrically connected to the first substrate 251 via at least one electrical connection member (e.g., a flexible printed circuit board (FPCB) or a flexible RF cable (FRC)). In an embodiment, the antenna member 253 may include a multi-function coil or multi-function core (MFC) antenna configured to execute a wireless charging function, a neat field communication (NFC) function, and/or an electronic payment function. In some embodiments, the second substrate 252 and/or the antenna member 253 may extend from the first space 2101 to the second space 2201 and may be electrically connected to the first substrate 251 through a flexibly deformable flexible substrate (a flexible printed circuit board (FPCB)).

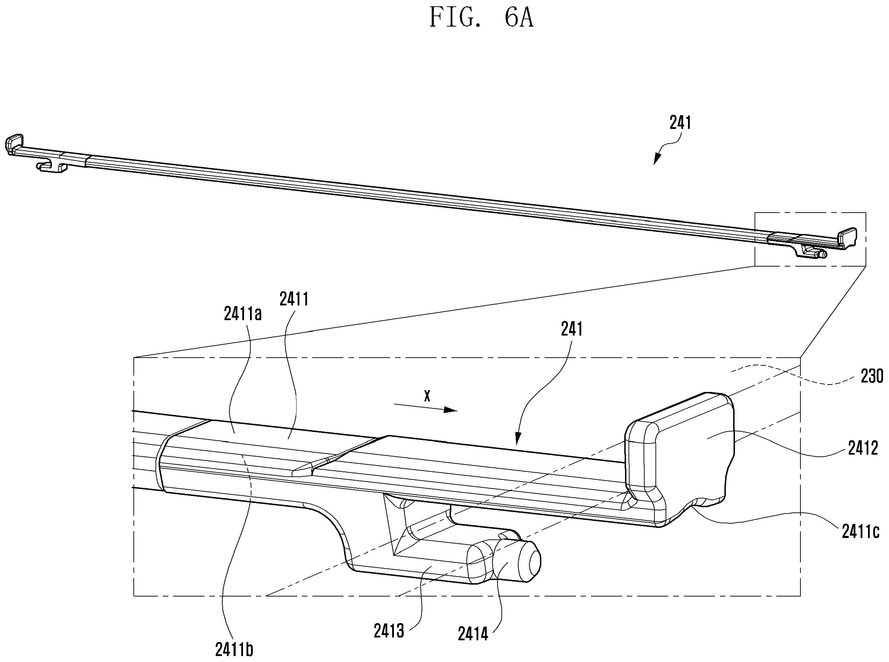

According to various embodiments, the electronic device 200 may include a pair of guide blocks 227 fixed to the second housing 220 and slidably coupled to a pair of guide rails 226. In an embodiment, through the slidable coupling of the guide rails 226 and the guide blocks 227, the second housing 220 may be slid out from the first housing 210 by a specific distance (e.g., the first distance L1 of FIG. 3A). In an embodiment, the guide blocks 227 may be detachably fixed through fastening members (e.g., the fastening member S of FIG. 6A) (e.g., screws).

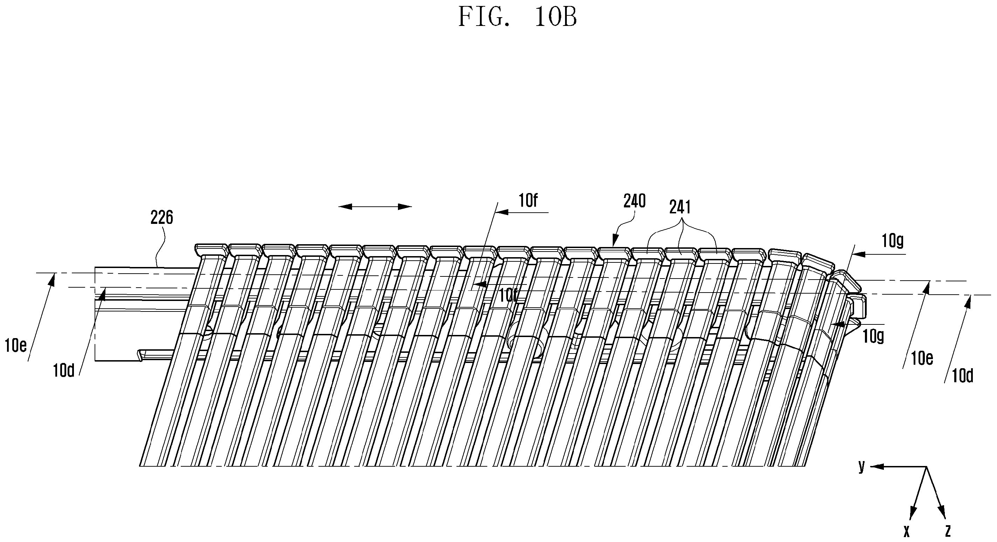

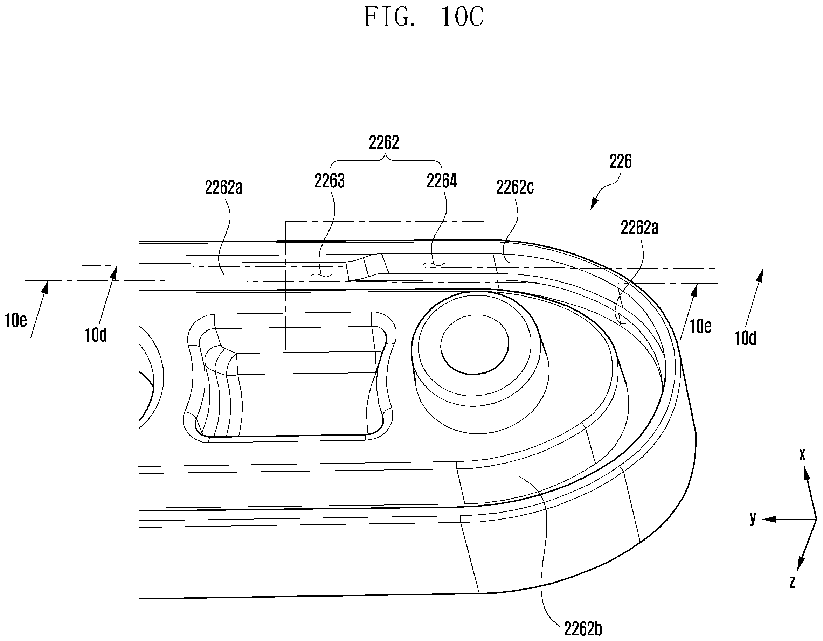

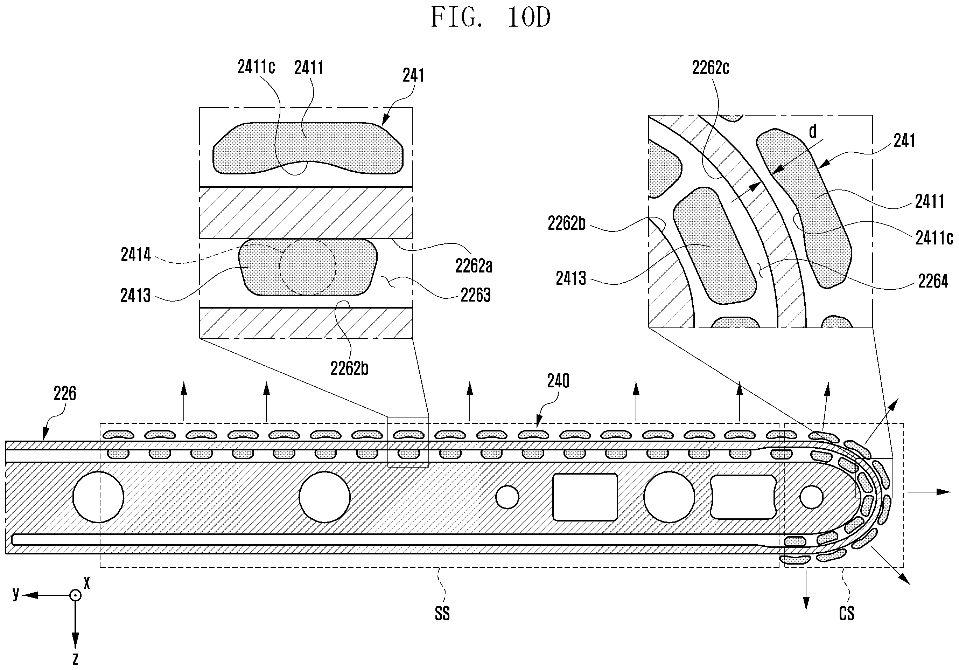

According to an example embodiment of the disclosure, the support member 240 may include multiple support bars (e.g., the support bars 241 in FIG. 10B) arranged at a specific interval on the rear surface of the flexible display 230. In an embodiment, each of the multiple support bars 241 may include a first guide protrusion (e.g., the first guide protrusion 2413 in FIG. 10D) and a second guide protrusion (e.g., the second guide protrusion 2414 in FIG. 10D) to be guided in a guide slit (e.g., the guide slit 2262 in FIG. 10C) provided in a guide rail 226. In an embodiment, the guide slit 2262 may include a linear section (e.g., the linear section SS in FIG. 10D) and a curved section (e.g., the curved section CS in FIG. 10D) extending from the linear section SS. In an embodiment, the guide slit 2262 may include a first guide slit (e.g., the first guide slit 2263 in FIG. 10C) extending from the linear section SS to the curved section CS and, in the curved section CS, a second guide slit (e.g., the second guide slit 2264 in FIG. 10C) extending from the first guide slit 2263 and including an inner surface positioned lower than an inner surface of the first guide slit 2263 (e.g., formed by material removal). In an embodiment, the first guide protrusion 2413 may be configured to be guided by the first guide slit 2263 in the linear section SS and to not come into contact with an inner surface of the guide slit 2262 by being received in the third guide slit 2264 in the curved section CS. In an embodiment, the second guide protrusion 2414 may be configured to be continuously guided by the first guide slit 2263 in both the linear section SS and the curved section CS. In an embodiment, in the linear section SS, a contact area between the first guide protrusion 2413 and the inner surface of the first guide slit 2263 may be greater than a contact area between the second guide protrusion 2414 and an inner surface of the second guide slit 2264 in the curved section CS, thereby inducing stable support for the flexible display 230. For example, in the linear section SS, at least the first guide protrusion 2413 and the first guide slit 2263 may be configured to be in surface contact, and in the curved section CS, the second guide protrusion 2414 and the first guide slit 2263 may be configured to be in line contact, thereby inducing a smooth guiding operation. For example, through the expanded contact area between the first guide protrusion 2413 and the inner surface of the first guide slit 2263 in the linear section SS of the guide slit (2262), smooth support for the flexible display 230 may be induced, and damage or deformation of the flexible display and/or the support bars due to external impact, such as, for example, a drop, may be mitigated.

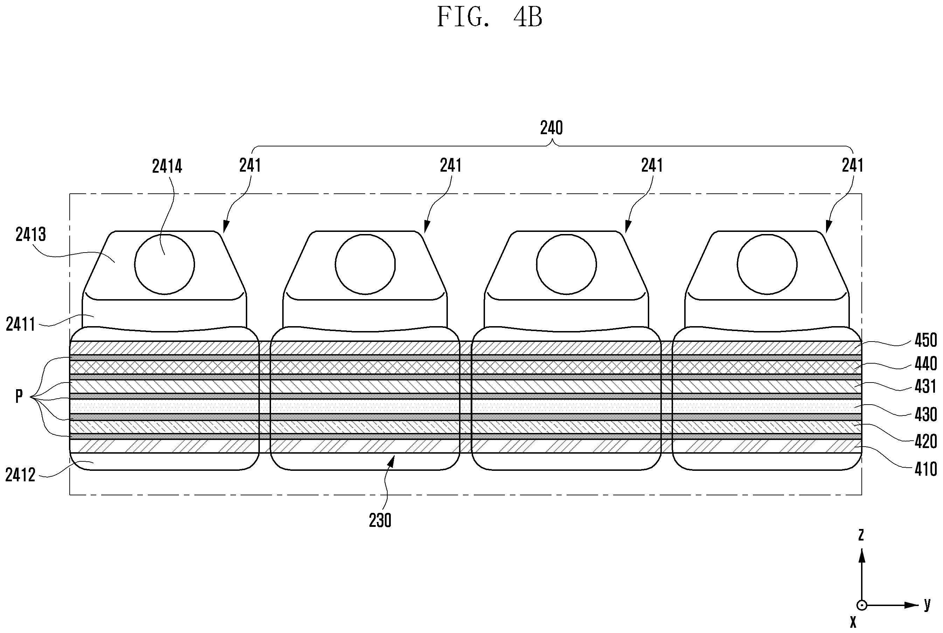

FIG. 4B is a partial cross-sectional view of the flexible display taken along line 4B-4B of FIG. 4A, according to various embodiments of the disclosure.

Referring to FIG. 4B, the flexible display 230 may include a window layer 410, and a polarizer (POL) 420 (e.g., a polarizing film), a display panel 430, a polymer layer 431, at least one functional layer 440, and a support plate 450, which are sequentially disposed on the rear surface of the window layer 410. In an embodiment, the electronic device 200 may include a support member 240 which is disposed below the functional layer 440 and supports at least a portion of the flexible display. In an embodiment, the support member 240 may include multiple support bars 241 attached to the rear surface of the support plate 450 at a predetermined interval through bonding or welding. In an embodiment, the window layer 410, the polarizer 420, the display panel 430, the polymer layer 431, the support plate 450, and the support member 240 may be attached to one another through adhesive layers P (e.g., an adhesive or bonding agent). For example, the adhesive layers P may include at least one of a pressure-sensitive adhesive (PSA), an optical clear adhesive (OCA), a heat-responsive adhesive, a general adhesive, or double-sided tape. In some embodiments, when the flexible display 230 is a POL-less display, the polarizing layer may be omitted, and a transparent reinforcement layer (e.g., a buffer layer) may be further disposed on that position. In some embodiment, the support plate 450 may be omitted.

According to various embodiments, the window layer 410 may include a glass layer. In an embodiment, the window layer 410 may include ultra-thin glass (UTG). In some embodiments, the window layer 410 may include polymer. In this case, the window layer 410 may include polyethylene terephthalate (PET) or polyimide (PI). In some embodiments, the window layer 410 may be arranged in multiple layers to include a glass layer and a polymer. In some embodiments, the flexible display 230 may further include a coating layer formed on at least a portion of the top surface, the rear surface, or the side surface of a glass layer formed as a part of the window layer 410 or a polymer (e.g., a protective film layer) disposed on the glass layer. For example, the coating layer may include a hard coating (HC) layer, an anti-reflection/low-reflection (AR/LR) coating layer, a shatter proof (SP) coating layer, or an anti-fingerprint (AF) coating layer. In some embodiments, the coating layer may be formed between the polymer and the glass layer, on the side surface of the polymer, or on at least one portion of the rear surface or the side surface of the glass layer.

According to various embodiments, the display panel 430 may include multiple pixels and a wiring structure (e.g., an electrode pattern). In an embodiment, the polarizer 420 may selectively allow light, which is generated from a light source of the display panel 430 and vibrates in a predetermined direction, to pass therethrough. In an embodiment, the display panel 430 and the polarizer 420 may be integrally formed. In an embodiment, the flexible display 230 may include a touch panel (not illustrated).

According to various embodiments, the polymer layer 431 may be disposed under the display panel 430, thereby providing a dark background for ensuring visibility of the display panel 430, and may be formed of a buffering material for a buffering action. In some embodiments, in order to ensure waterproofing of the flexible display 230, the polymer layer 431 may be removed or disposed under the support plate 450.

According to various embodiments, the flexible display 230 may further include at least one functional layer 440 disposed below the polymer layer 431. According to an embodiment, the functional layer 440 may include a protective layer (e.g., a TPU layer) for reducing deformation caused by the bending of the support member 240, a graphite sheet for heat dissipation, a force-touch FPCB, a fingerprint sensor FPCB, a communication antenna radiator, a conductive/non-conductive tape, or a digitizer. In an embodiment, the digitizer may include multiple conductive patterns (e.g., coil patterns) disposed on a dielectric substrate (e.g., a dielectric film or a dielectric sheet) to detect a resonant frequency induced by an electromagnetic induction method applied from an electronic pen.

According to various embodiments, the support plate 450 may provide rigidity and flexibility to the flexible display 230. For example, the support plate 450 may be formed of a non-metallic sheet material, such as, for example, fiber-reinforced plastics (FRP) (e.g., carbon fiber-reinforced plastics (CFRP) or glass fiber-reinforced plastics (GFRP)), having a rigid property to support the display panel 430. In an embodiment, the support plate 450 may include a pattern that is disposed in an area corresponding to the support member 240, thereby helping improve the flexibility of the flexible display 230. In an embodiment, the pattern may include multiple openings and/or recesses arranged at a predetermined interval. The bending characteristics of the support plate 450 may be determined by at least one of the size, shape, or arrangement density of at least some of the multiple openings and/or multiple recesses. In some embodiments, the support plate 450 may be formed of a metal material such as, for example, SUS, Cu, Al, or a metal clad (e.g., a laminated member in which SUS and Al are alternately disposed). In an embodiment, the support plate 450 may help reinforce the rigidity of the electronic device 200, may shield ambient noise, and may be used as heat dissipation means to disperse heat emitted from surrounding heat-emitting components.

According to various embodiments, the support member 240 may include multiple support bars 241 arranged at a predetermined interval and attached to the rear surface of the support plate 450. In an embodiment, each of the multiple support bars 241 may include first guide protrusions 2413 and second guide protrusions 2414 to have predetermined protrusion amounts from both side surfaces. In an embodiment, the second guide protrusions 2414 may extend from the first guide protrusions 2413. In some embodiments, the second guide protrusions 2414 may protrude separately from both ends of the support bar 241, independent of the first guide protrusions 2413. In an embodiment, each of the first guide protrusion 2413 may be configured to be guided in the linear section SS (e.g., the linear section SS in FIG. 10D) of a guide slit to be described later (e.g., the guide slit 2262 in FIG. 10C), and not in the curved section CS extending from the linear section SS, whereas each of the second guide protrusions 2414 may be configured to be guided in both the linear section SS and the curved section CS.

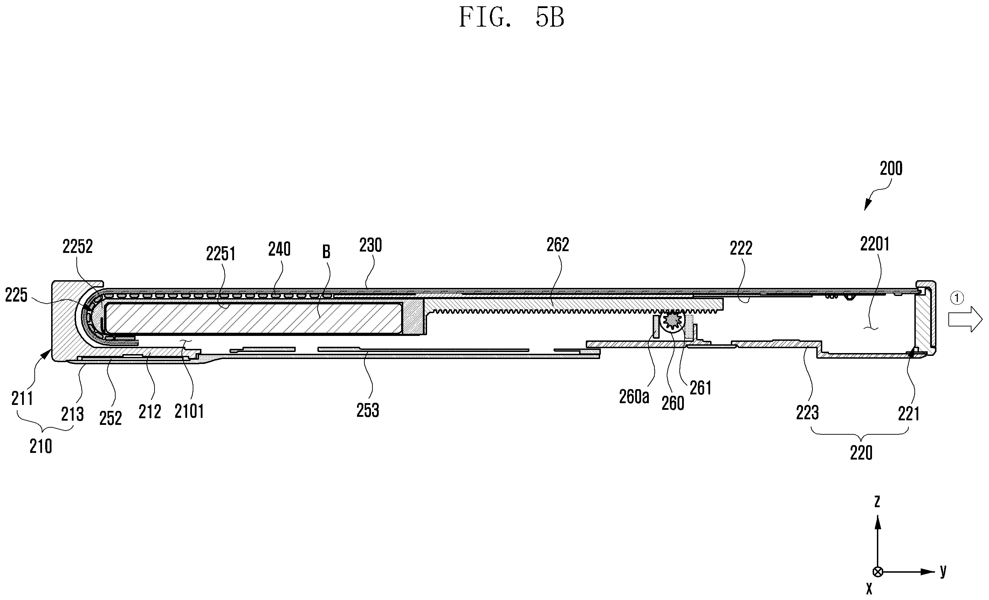

FIG. 5A is a cross-sectional view of the electronic device according to various embodiments of the disclosure taken along line 5a-5a in FIG. 2A. FIG. 5B is a cross-sectional view of the electronic device according to various embodiments of the disclosure taken along line 5b-5b in FIG. 3A.

In describing the electronic device 200 of FIGS. 5A and 5B, the same reference numerals are assigned to components that are substantially the same as those of the electronic device 200 of FIG. 4A, and detailed descriptions thereof may be omitted.

Referring to FIGS. 5A and 5B, the electronic device 200 may include a first housing 210 having a first space 2101, a second housing 220 having a second space 2201, a support member 240 connected to the second housing 220 and at least partially accommodated in the first space 2101 in the slide-in state, a flexible display 230 disposed to be supported by at least a portion of the support member 240 and at least a portion of the second housing 220, a rack gear 262 fixed in the first space 2101 and extending into the second space 2201, and a drive motor 260 disposed in the second space 2201 and including a pinion gear 261 gear-engaged with the rack gear 262. In an embodiment, the drive motor 260 may automatically move the second housing 220 in the slide-out direction (direction ①) or the slide-in direction (direction ②) relative to the first housing 210 through the gear engagement between the pinion gear 261 and the rack gear 262. In some embodiments, by changing the disposition of the drive motor 260 and the rack gear 262, the first housing 210 may be automatically moved in the slide-out direction (direction ②) or the slide-in direction (direction ①) from the second housing 220. In an embodiment, the first housing 210 may include a first side surface member 211 and a first rear surface cover 213 coupled to a first extension member 212 extending from the first side surface member 211. In an embodiment, the second housing 220 may include a second side surface member 221 and a second rear surface cover 223 coupled to a second extension member 222 extending from the second side surface member 221.

According to various embodiments, a portion of the second housing 220 may be accommodated in the first space 2101 of the first housing 210 in the slide-in state of the electronic device 200 (the state of FIG. 5A). In an embodiment, at least a portion of the flexible display 230 may be accommodated in the first space 2101 in a bending manner together with the support member 240, thereby being disposed such that the portion is invisible from the outside. In this case, a first display area of the flexible display 230 (e.g., the display area corresponding to the first portion 230a in FIG. 3A) may be exposed to the outside.

According to various embodiments, at least a portion of the second housing 220 may transition to the slide-out state in which the second housing is at least partially moved to the outside from the first housing 210 along the first direction (direction ①) through the driving of the drive motor 260. In an embodiment, in the slide-out state of the electronic device 200 (the state of FIG. 5B), the flexible display 230 may be supported by the support bracket 225 and may move together with the support member 240, thereby exposing the portion accommodated in the first space 2101 to be at least partially visible from the outside. In this case, in the flexible display 230, a second display area (e.g., a display area including the first portion 230a and the second portion 230b in FIG. 3A) that is greater than the first display area may be exposed to the outside. In some embodiments, the rack gear 262 may be disposed in the second housing 220, and the drive motor 260 including the pinion gear 261 may be disposed in the first housing 210.

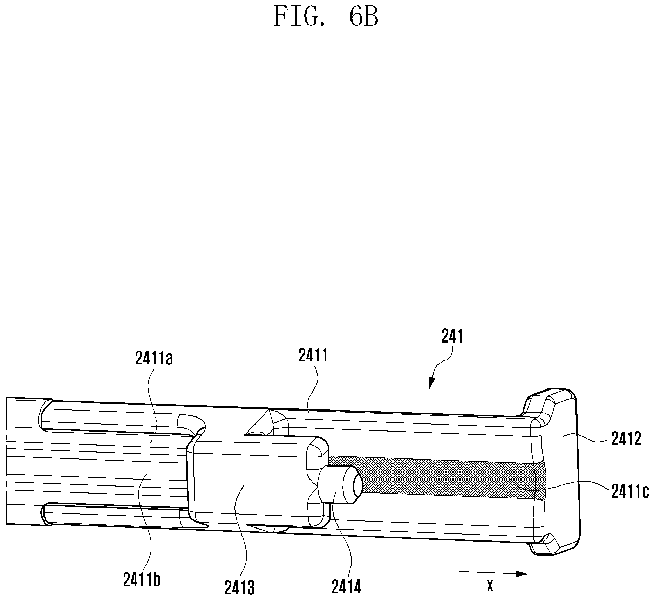

FIG. 6A is a perspective view of a support bar according to various embodiments of the disclosure. FIG. 6B is a perspective view of a portion of the support bar according to various embodiments of the disclosure.

Referring to FIGS. 6A and 6B, a support member (e.g., the support member 240 in FIG. 4B) may include multiple support bars 241 disposed on the rear surface of the flexible display 230. In an embodiment, each of the support bars 241 (hereinafter referred to as a "support bar") may include a bar-shaped support portion 2411 having a length and a head portion 2412 formed at an end of the support portion 2411. In an embodiment, the support portion 2411 may be fabricated to have a length in a direction (e.g., the -x-axis direction) perpendicular to a sliding direction (e.g., the y-axis direction in FIG. 4A) of the second housing (e.g., the second housing 220 in FIG. 4A). In an embodiment, the support portion 2411 may include a first surface 2411a and a second surface 2411b facing away from the first surface 2411a. In an embodiment, the first surface 2411a may support the flexible display 230 by being in contact with the rear surface of the flexible display 230. In an embodiment, the support member 240 may accommodate the bending characteristics of the flexible display 230 when the multiple support bars 241 are arranged at a specific interval from one another. In an embodiment, the head portion 2412 may be provided higher than the first surface 2411a from the end of the support portion 2411, thereby supporting a margin (e.g., an edge) of the flexible display 230 disposed on the first surface 2411a. In an embodiment, the support portion 2411 may include a curved groove 2411c along its longitudinal direction on the second surface. In an embodiment, the curved groove 2411c may be configured to induce a minimal gap with an outer surface of the guide rail 226 when the support bar 241 moves along the curved section CS of the guide rail 226, thereby helping stable guiding operation. In an embodiment, the support bar 241 may be formed of metal and/or a rigid polymer.

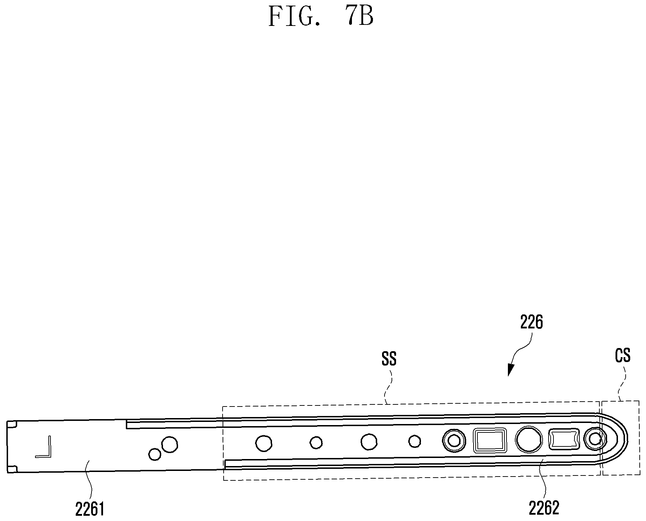

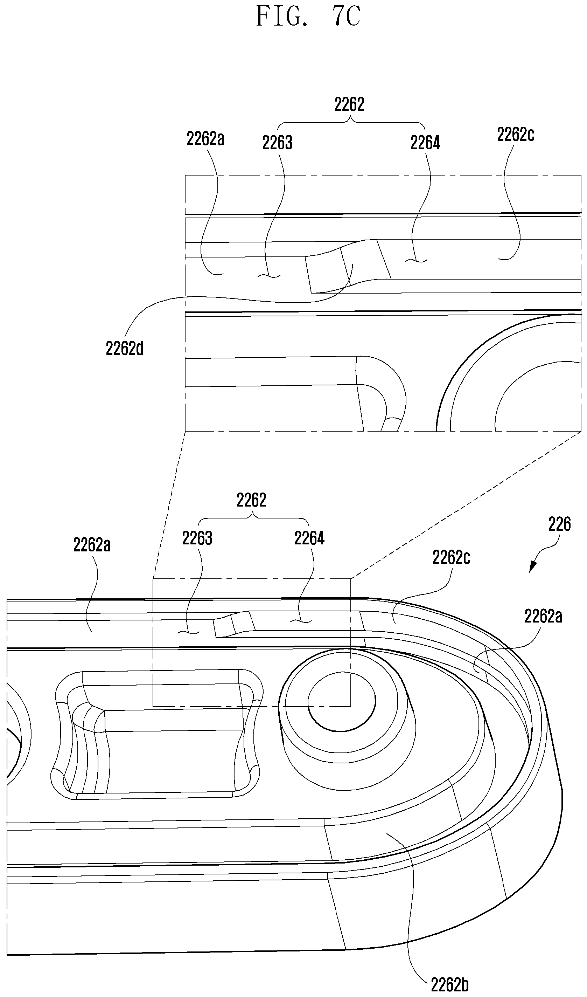

According to various embodiments, the support bar 241 may include a first guide protrusion 2413 extending from the second surface 2411b in a direction parallel to a longitudinal direction (-x-axis direction) of the support portion 2411 by a predetermined length, and a second guide protrusion 2414 extending in the same direction from the first guide protrusion 2413. In an embodiment, the top surface of the first guide protrusion 2413 (e.g., the surface facing the second surface 2411b) may have a greater area than the top surface of the second guide protrusion 2414 (e.g., the surface facing the second surface 2411b). For example, in at least some sections (e.g., the linear section SS in FIG. 7B) of a guide slit (e.g., the guide slit 2262 in FIG. 7C) formed in the guide rail (e.g., the guide rail 226 in FIG. 7C), by expanding the contact area between the top surface of the first guide protrusion 2413 and the inner surface of the guide slit 2262, strong support for the flexible display 230 may be induced, and in the event of an impact such as, for example, a drop, the likelihood of damage or deformation of the flexible display 230 and/or the support member 240 may be reduced. In an embodiment, the first guide protrusion 2413 and the second guide protrusion 2414 may be disposed at a position overlapping at least the support portion 2411 when the first surface 2411a is viewed from above. Through this arrangement, when the guide rail 226 is coupled to accommodate the guide protrusions 2413 and 2414, at least a portion of the guide rail 226 may overlap the support portion 2411 when the first surface 2411a is viewed from above, thereby helping slim the electronic device 200.

In some embodiments, the first guide protrusion 2413 and the second guide protrusion 2414 may individually extend from different positions on the second surface 2411b. In this case, the first guide protrusion 2413 and the second guide protrusion 2414 may extend to different lengths. In some embodiments, the second guide protrusion 2414 may be formed first, and the first guide protrusion 2413 may extend from the second guide protrusion 2414.

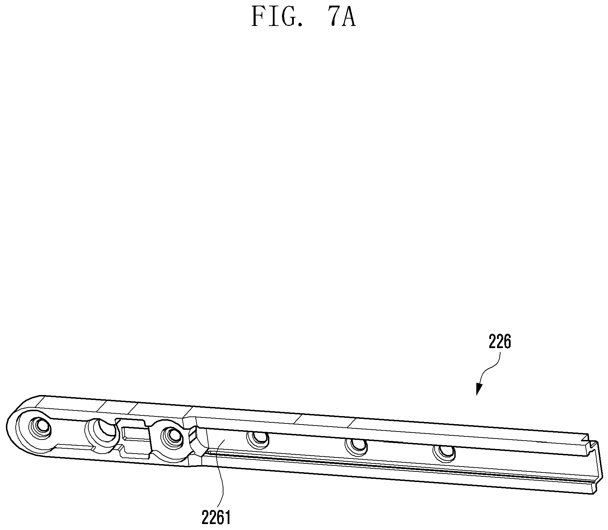

FIG. 7A is a perspective view of a guide rail according to various embodiments of the disclosure. FIG. 7B is a front view of the guide rail according to various embodiments of the disclosure. FIG. 7C is a perspective view of a portion of the guide rail according to various embodiments of the disclosure.

Referring to FIGS. 7A to 7C, a pair of guide rails 226 may be disposed inside an inner space (e.g., the first space 2101 in FIG. 4A) of the first housing (e.g., the first housing 210 in FIG. 4A) to have a length along the sliding direction (e.g., the ±y-axis direction in FIG. 4A) of the second housing (e.g., the second housing 220 in FIG. 4A). In an embodiment, the pair of guide rails 226 may be fixed to both side surfaces inside the inner space 2101 of the first housing 210. In an embodiment, the pair of guide rails 226 (hereinafter referred to as a "guide rail") may respectively include guide slits 2262 (e.g., guide slots, guide grooves, guide holes, guide recesses, or guide trenches) configured to guide first guide protrusions (e.g., the first guide protrusions 2413 in FIG. 6A) and second guide protrusions (e.g., the second guide protrusions 2414 in FIG. 6A) protruding from both ends of each of support bars (e.g., the support bars 241 of FIG. 6A) of a support member (e.g., the support member 240 in FIG. 4A). In an embodiment, the guide slits 2262 may each include a linear section SS and a curved section CS extending from the linear section SS. In an embodiment, the guide slits 2262 may be positioned lower than outer surfaces 2261 of the guide rails 226 and may have a length along the sliding direction of the second housing 220, thereby at least partially accommodating the first guide protrusions 2413 and the second guide protrusions 2414 of the support bars 241. In an embodiment, the linear section SS may guide the support member 240 in the sliding direction, thereby inducing movement of the flexible display (e.g., the flexible display 230 in FIG. 4A). In an embodiment, the curved section CS may cause a portion of the flexible display 230 and the support member 240, which have moved through the linear section SS, to bend and move into the inner space 2101 of the first housing 210.

According to various embodiments, the guide slit 2262 may include a first guide slit 2263, which extends from the linear section SS to the curved section CS, and a second guide slit 2264, which extends from the first guide slit 2263 in the curved section CS and is positioned lower than an inner surface of the first guide slit 2263 (e.g., formed by material removal). For example, in the curved section CS, the guide space per unit volume defined by the first guide slit 2263 and the second guide slit 2264 may be configured to be larger than the guide space per unit volume provided by the first guide slit 2263 in the linear section SS. Accordingly, in the linear section SS, the first guide slit 2263 may be configured such that its inner surface comes into contact with both the first guide protrusions 2413 and the second guide protrusion 2414 of the support bars 241 or at least the first guide protrusions 2413. In an embodiment, in the curved section CS, the second guide slit 2264 may be configured such that the inner surface of the second guide slit 2264 does not come into contact with the first guide protrusions 2413, and only the inner surface of the first guide slit 2263 comes into contact with the inner surfaces of the second guide protrusions 2414. Through this dual-guiding structure, in the linear section SS, which has a relatively long guide section, the contact area between the first guide protrusions 2413 and the inner surface of the first guide slit 2263 may be expanded. The expanded contact area may induce stable support for the flexible display 230 and may help reduce the likelihood of damage or deformation of the flexible display 230 and/or the support member 240 due to external impacts such as, for example, drops.

According to various embodiments, the guide slit 2262 may include an inner surface. In an embodiment, the inner surface may include a first inner surface 2262a, which faces in a direction toward the flexible display 230 and extends from the linear section SS toward the curved section CS. In an embodiment, the inner surface may include a second inner surface 2262b, which is formed in a direction opposite to the first inner surface 2262a and extends from the linear section SS to the curved section CS. In an embodiment, the inner surface may include a third inner surface 2263c, which extends from a portion of the first inner surface 2262a in the curved section CS. In an embodiment, the third inner surface 2263c may be positioned lower than the first inner surface 2262a. For example, the third inner surface 2263c may be positioned lower than the first inner surface 2262a through material removal. Accordingly, the first guide slit 2263 may be provided through the space between the first inner surface 2262a and the second inner surface 2262b in both the linear section SS and the curved section CS. In an embodiment, the second guide slit 2264 may be provided through the space between the second inner surface 2262b and the third inner surface 2263c in the curved section CS. In an embodiment, the inner surface may include an inclined surface 2262d formed to connect the first inner surface 2262a and the third inner surface 2262c in a boundary area between the linear section SS and the curved section CS. In an embodiment, the inclined surface 2262d may be gradually lowered from the first inner surface 2262a toward the third inner surface 2262c. This inclined surface 2262d may help induce the smooth guiding of the first guide protrusions 2413 moving from the curved section CS to the linear section SS. In some embodiments, the inclined surface 2262d may be replaced with a connection surface that tangentially connects the first guide slit 2263 to the second guide slit 2264.

According to various embodiments, in the linear section SS, the first guide protrusions 2413 and the second guide protrusions 2414 of the support bars 241 may be configured to move while being in contact with the first inner surface 2262a. In an embodiment, in the curved section CS, the second guide protrusions 2414 (and not the first guide protrusions 2413) may be configured to move while being in contact with the first inner surface 2262a. For example, the first guide protrusions 2413 may be configured to not come into contact with the second inner surface 2262b and the third inner surface 2262c by the second guide slit 2264, which has a relatively large space.

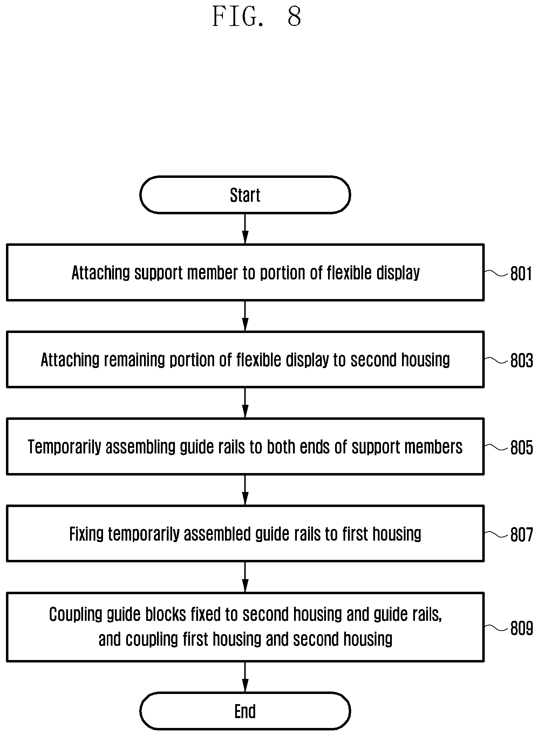

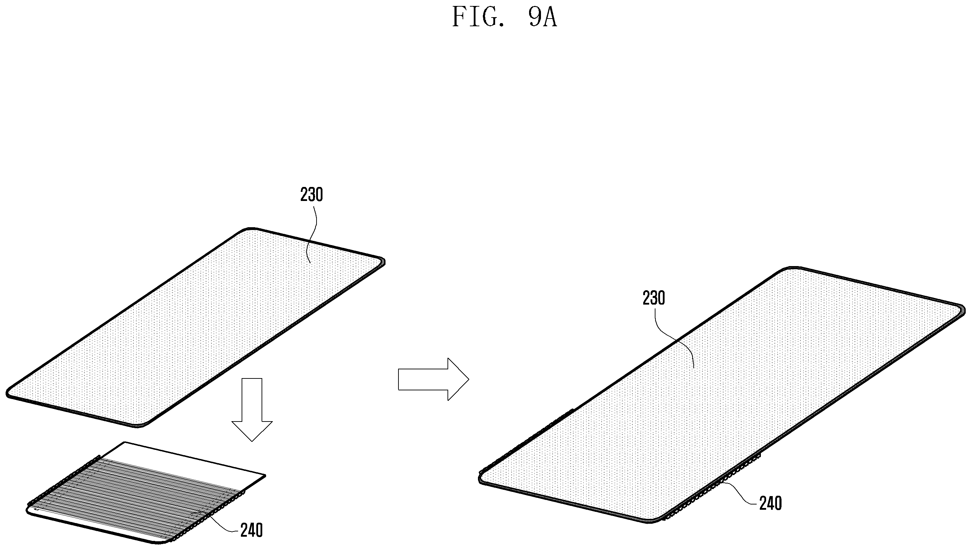

FIG. 8 is a flowchart illustrating an assembly process of an electronic device according to various embodiments of the disclosure. FIGS. 9A to 9E are views illustrating the assembly process of the electronic device according to various embodiments of the disclosure.

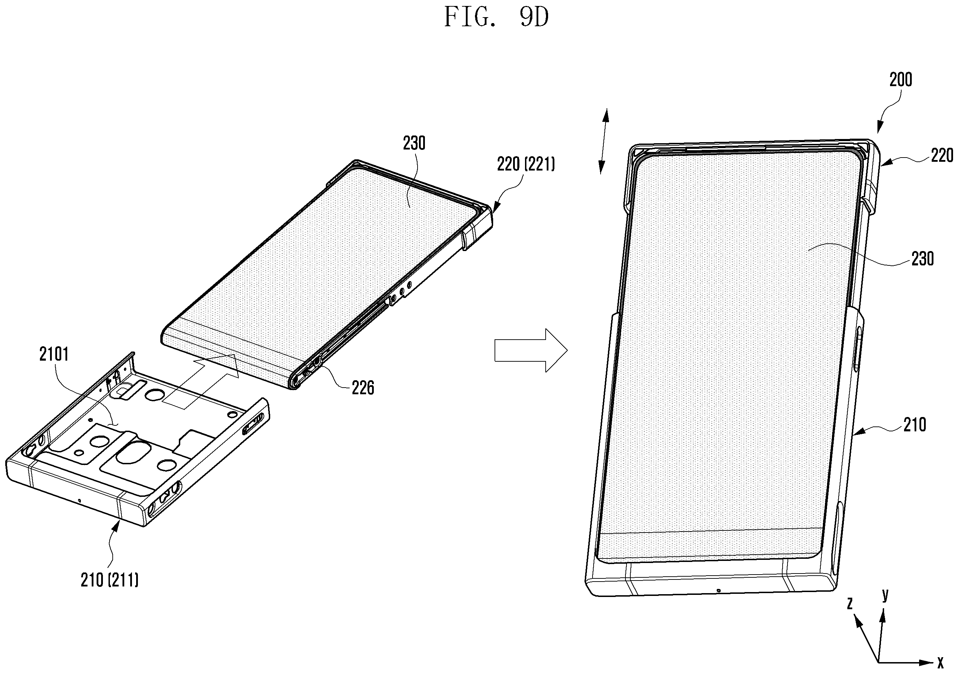

Referring to FIGS. 8 to 9E, in operation 801, referring to FIG. 9A, the support member 240 may be attached to a portion of the flexible display 230. In an embodiment, the support member 240 may include multiple support bars (e.g., the support bars 241 in FIG. 6A), and each of the support bars 241 may be attached to the rear surface of the flexible display 230 at a predetermined interval. For example, the support bars 241 may be attached to corresponding areas of the flexible display 230 that undergo deformation by bending when the electronic device (e.g., the electronic device 200 of FIG. 9D) transitions from the slide-in state to the slide-out state or from the slide-out state to the slide-in state.

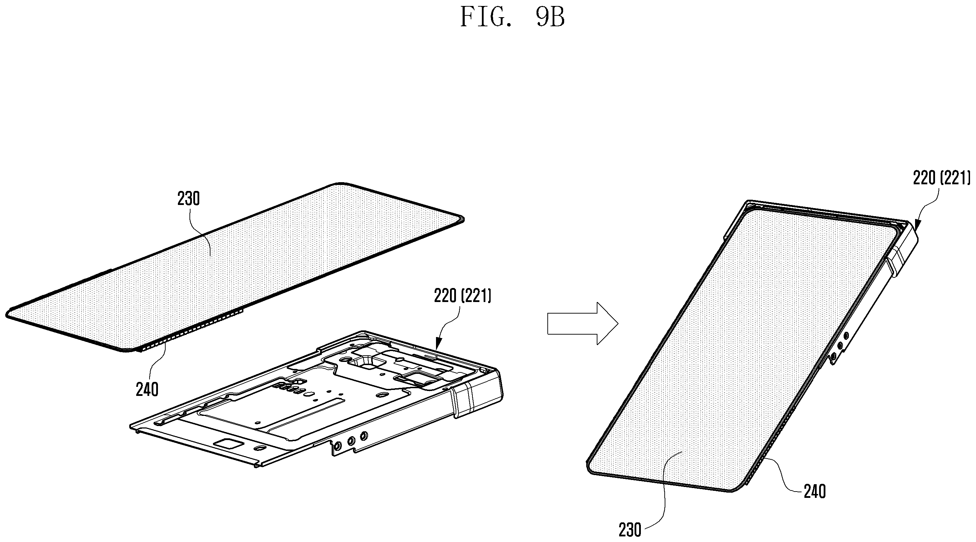

In operation 803, referring to FIG. 9B, the remaining portion of the flexible display 230 may be attached or fixed to at least a portion of the second housing 220. In an embodiment, the remaining portion of the flexible display 230 may be disposed to be attached to at least a portion of the second side surface member 221. In this case, the portion of the flexible display 230 to which the support member is attached may not overlap the second housing 220.

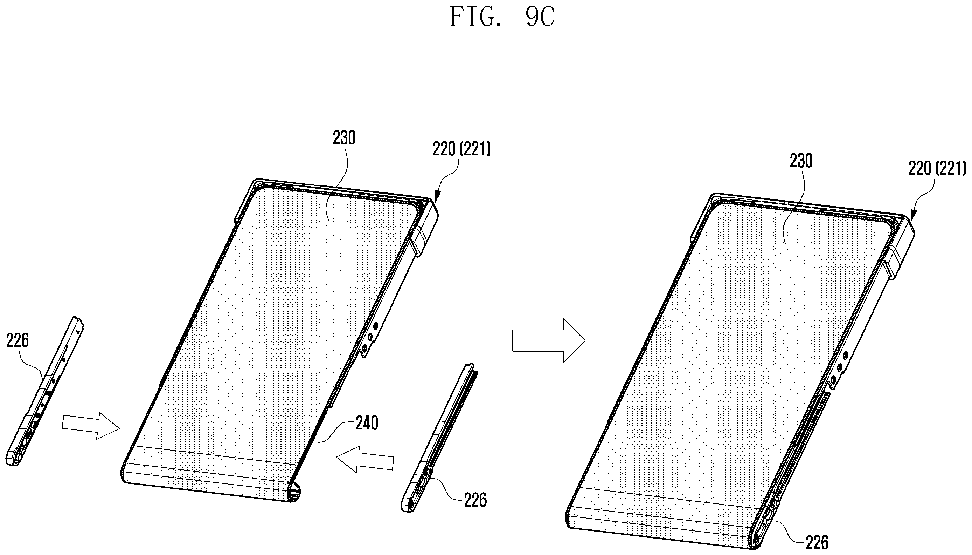

In operation 805, referring to FIG. 9C, a pair of guide rails 226 may be temporarily assembled at both ends of the support member 240. In this case, guide protrusions (e.g., the first guide protrusions 2413 and/or the second guide protrusions 2414 in FIG. 6A) protruding from both ends of each of the multiple support bars 241 of the support member 240 may be disposed such that the guide protrusions are at least partially accommodated within guide slits (e.g., the guide slits 2262 in FIG. 7C) formed in the guide rails 226.

In operation 807, referring to FIG. 9D, the temporarily assembled guide rails 226 may be fixed to the first housing 210. In this case, the guide rails 226 may be in contact with an inner surface within the inner space 2201 of the first housing 210 and may be fixed using one or more screws provided on an outer surface of the first housing 210.

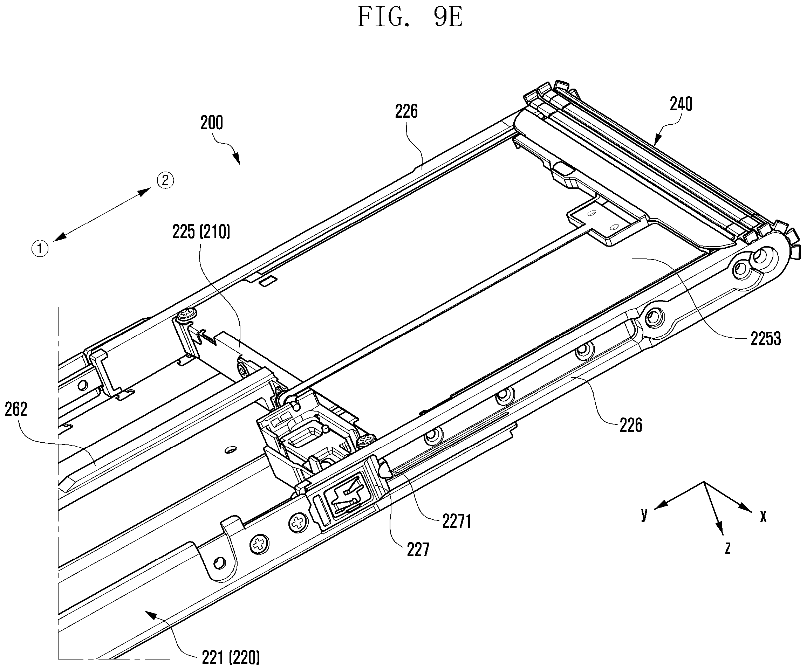

In operation 809, referring to FIG. 9E, when the guide rails 226 are assembled to the first housing 210, the guide rails 226 may be slidably coupled to the guide blocks 227 fixed to the second housing 220. In an embodiment, when the guide rails 226 are coupled to the guide blocks 227, the first housing 210 and the second housing 220 may be additionally slidably coupled to each other through a guiding structure separately provided on the first side surface member 211 and the second side surface member 221, thereby completing the electronic device 200. In an embodiment, when the guide rails 226 are assembled with the guide blocks 227, the guide rails 226 may be prevented from moving outward by a stopper 2271 disposed in the guide blocks 227. In some embodiments, in operation 805, the guide blocks 227 may already be slidably coupled to the guide rails 226.

Accordingly, when the second housing 220 moves relative to the first housing 210 in the slide-out direction (e.g., direction ①) or the slide-in direction (e.g., direction ②), the support member 240 may move together with the second housing 220 while being guided by the guide rails 226.

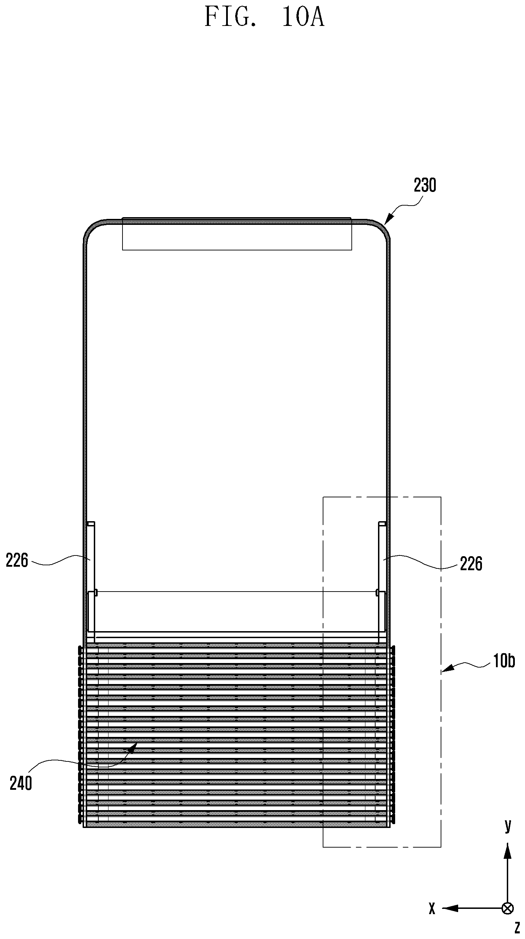

FIG. 10A is a view illustrating a state in which a support member disposed on a flexible display is coupled to guide rails, according to various embodiments of the disclosure. FIG. 10B is a partial perspective view illustrating area 10b of FIG. 10A, according to various embodiments of the disclosure. FIG. 10C is a partial perspective view of a guide rail, according to various embodiments of the disclosure.

Referring to FIGS. 10A to 10C, the support member 240 may be attached to a portion of the flexible display 230. In an embodiment, the support member 240 may include multiple support bars 241, and each of the support bars 241 may be attached to the rear surface of the flexible display 230 at a specific interval. For example, the support bars 241 may be attached to corresponding areas of the flexible display 230 that undergo deformation by bending when the electronic device transitions from the slide-in state to the slide-out state or from the slide-out state to the slide-in state.

According to various embodiments, the guide rails 226 may be coupled to both ends of the support member 240. In this case, guide protrusions (e.g., the first guide protrusions 2413 and/or the second guide protrusions 2414 of FIG. 6A) protruding from both ends of each of the multiple support bars 241 of the support member 240 may be disposed such that the guide protrusions are at least partially accommodated within guide slits 2262 formed in the guide rails 226.

According to various embodiments, the guide slits 2262 may each include a first guide slit 2263 formed through a space between a first inner surface 2262a and a second inner surface 2262b and a second guide slit 2264 formed through a space between the second inner surface 2262b and a third inner surface 2262c. In an embodiment, the first guide slit 2263 may be formed from the linear section SS to the curved section CS of the guide slit 2262. In an embodiment, the second guide slit 2264 may be provided through the space between the second inner surface 2262b and the third inner surface 2262c in the curved section CS.

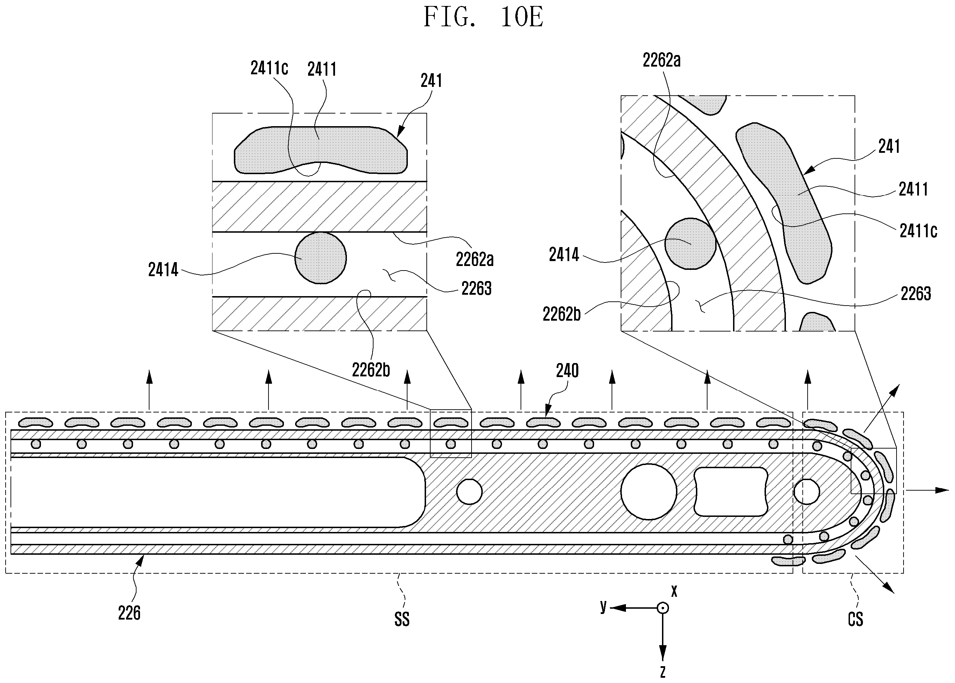

FIG. 10D is a cross-sectional view of a guide rail coupled with a support member, illustrated along line 10d-10d of FIGS. 10B and 10C, according to various embodiments of the disclosure. FIG. 10E is a cross-sectional view of the guide rail coupled with a support member, illustrated along line 10e-10e of FIGS. 10B and 10C, according to various embodiments of the disclosure.

Referring to FIG. 10D, in the linear section SS, the first guide protrusions (e.g., the first guide protrusions 2413 in FIG. 10D) may come into with the first inner surface 2262a within the first guide slit 2263. In some aspects, the second guide protrusions (e.g., the second guide protrusions 2414 in FIG. 10D) may also come into contact with the first inner surface 2262a. This occurs due to the restoring force that causes the flexible display 230 to unfold outward (indicated by the arrows) when the guide protrusions 2413 and 2414 of the support bars 241 are accommodated in the guide slit 2262. In some embodiments, in the linear section SS, the second guide protrusions 2414 may be configured to not come into contact with the first inner surface 2262a. In an embodiment, in the curved section CS, the first guide protrusions 2413 may be accommodated in the second guide slit 2264 and may not come into contact with the third inner surface 2262c. In an embodiment, in the curved section CS, the first guide protrusions 2413 may be accommodated in the second guide slit 2264 and may not come into contact with the second inner surface 2262b. In an embodiment, when the support bars 241 move through the curved section CS of the guide slit 2262, the curved groove 2411c formed in the support bars 241 may help minimize the gap d between the support bars 241 and the outer surface of the guide rail 226, thereby helping stable guiding operation.

Referring to FIG. 10E, in the linear section SS, the second guide protrusions 2414 may be in contact with the first inner surface 2262a within the first guide slit 2263. In an embodiment, in the curved section CS, the first guide protrusions 2413 may be in contact with the first inner surface 2262a within the first guide slit 2263. This occurs due to the restoring force that causes the flexible display 230 to unfold outward (indicated by the arrows) when the guide protrusions 2413 and 2414 of the support bars 241 are accommodated in the guide slit 2262.

According to various embodiments, in the linear section SS, the contact area between the first guide protrusions 2413 and the first inner surface 2262a of the first guide slit 2263 may be greater than the contact area between the second guide protrusions 2414 and the first inner surface 2262a of the first guide slit 2263. For example, in the curved section CS, the first guide protrusions 2413 may be accommodated in the second guide slit 2264 and configured to not come into contact with the second inner surface 2262b and the third inner surface 2262c, thereby remaining free from interference in the curved section CS. In this case, since the second guide protrusions 2414 are also accommodated in the first guide slit 2263 extending from the linear section SS to the curved section CS and are guided while being in contact with the first inner surface 2262a, the second guide protrusions may induce a stable guiding operation of the support bars 241. Accordingly, without considering the guiding structure between the first guide protrusions 2413 and the first guide slit 2263 in the curved section CS, the contact area between the first guide protrusions 2413 and the first inner surface 2262a of the first guide slit 2263 may be expanded in the linear section SS which has a relatively long guide section. The expanded contact area may induce stable support for the flexible display 230 and may help reduce the likelihood of damage or deformation of the flexible display 230 and/or the support members 240 due to external impacts such as, for example, drops.

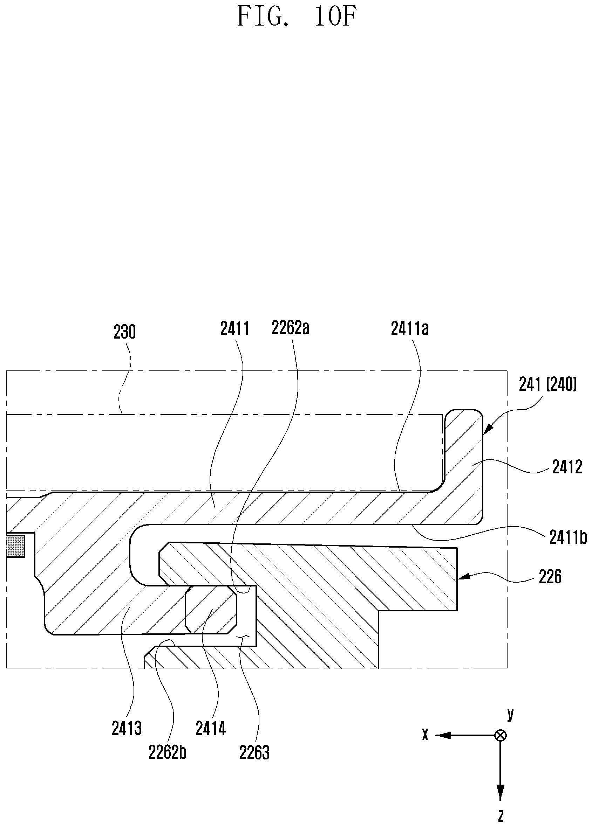

FIG. 10F is a cross-sectional view illustrating a state in which a support member and a guide rail are coupled, taken along line 10f-10f of FIG. 10B, according to various embodiments of the disclosure.

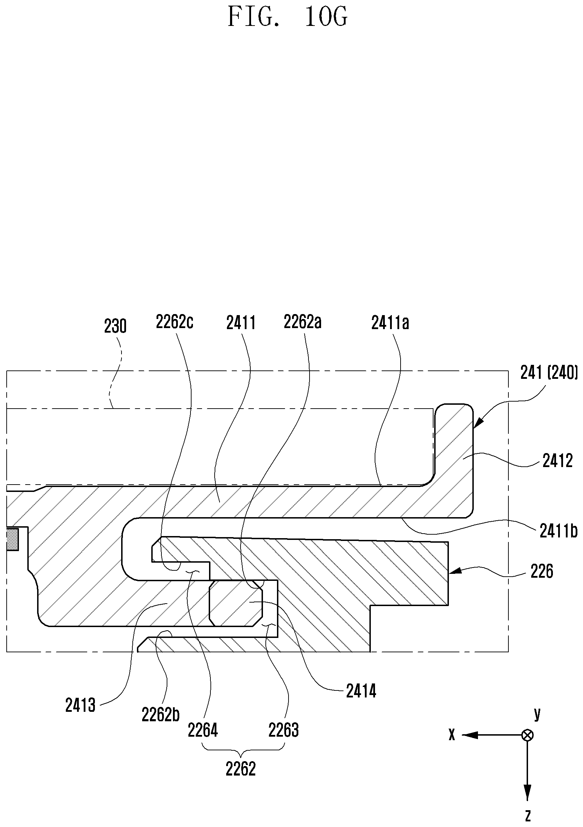

Referring to FIG. 10F, in the linear section SS of the guide slit 2262, the first guide protrusions 2413 and the second guide protrusions 2414 may be accommodated in the first guide slit 2263 of the guide rail 226 and may be guided while being in contact with the first inner surface 2262a. In an embodiment, in the linear section SS, by expanding the contact area (e.g., surface contact) between the first guide protrusions 2413 and the first inner surface 2262a, stable support for the support bars 241 may be induced, and this may help reduce the likelihood of damage or deformation of the flexible display 230 and/or the support member 240 due to external impacts such as, for example, drops. FIG. 10G is a cross-sectional view illustrating a state in which a support member and a guide rail are coupled, taken along line 10g-10g of FIG. 10B, according to various embodiments of the disclosure.

Referring to FIG. 10G, in the curved section CS of the guide slit 2262, the first guide protrusion 2413 may be accommodated in the second guide slit 2264 but may not be come in contact with the second inner surface 2262b and the third inner surface 2262c. The second guide protrusion may be in contact with the first inner surface 2262a, and not be contact with the second inner surface 2262b and the third inner surface 2262c. By reducing the contact area (e.g., line contact), this configuration may help the smooth guiding operation of the support bar 241.

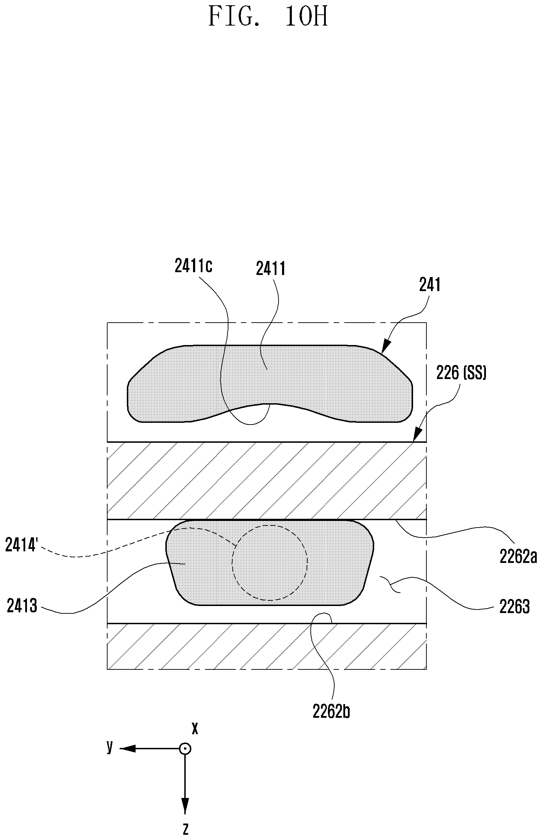

FIG. 10H is a view illustrating the arrangement of a first guide protrusion and a second guide protrusion in the linear section, according to various embodiments of the disclosure.

As illustrated in FIG. 10H, in the linear section SS, the first guide protrusion 2413 and the second guide protrusion 2414 of a support bar 241 may be accommodated in the first guide slit 2263 of the guide rail 226. In an embodiment, the first guide protrusion 2413 may be in contact with the first inner surface 2262a of the first guide slit 2263. In an embodiment, the second guide protrusion 2414 may be disposed to be not in contact with the first inner surface 2262a of the first guide slit 2263.

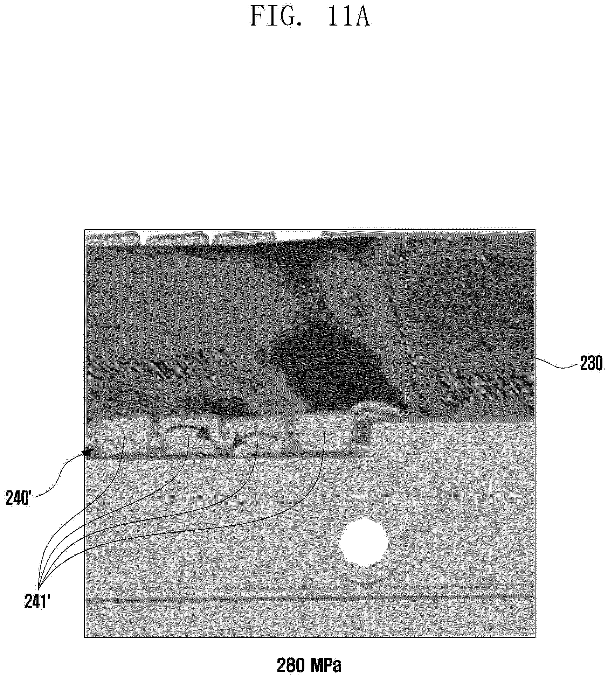

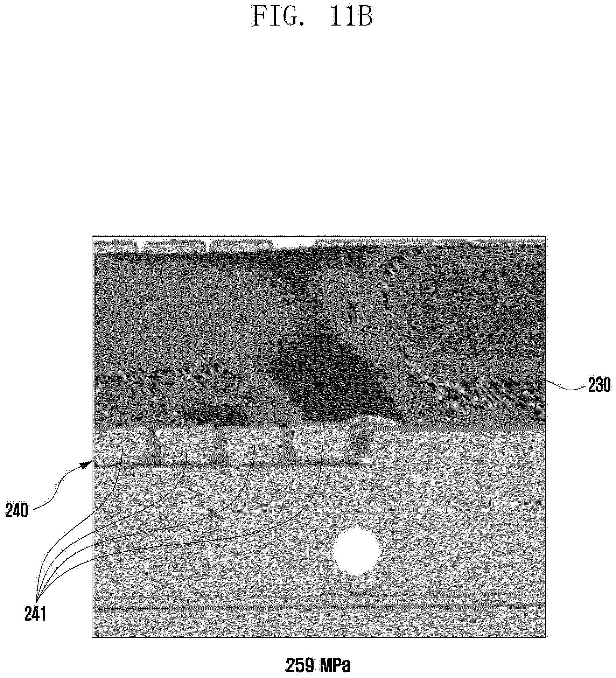

FIGS. 11A and 11B are views comparing the stress applied to the flexible display during a drop impact between a guiding structure of a comparative example and a guiding structure according to various embodiments of the disclosure.

Referring to FIGS. 11A and 11B, in the comparative example (FIG. 11A), where the first guide protrusions of the support bars 241' of the support member 240', which are configured considering the guiding operation in the curved section CS make contact (e.g., line contact) with the first inner surface, the stress applied to the flexible display 230 under an external impact is about 280 MPa. In contrast, in the disclosure (FIG. 11B), where, regardless of the guiding operation in the curved section CS, the first guide protrusions 2413 make expanded contact (e.g., surface contact) with the first inner surface 2262a in the linear section SS, the stress applied to the flexible display 230 under the same external impact is approximately 259 MPa, representing a reduction of about 7.5%. This result may mean that as the contact area between the guide protrusions 2413 of the support bars 241 and the inner surface 2262a of the guide slit 2263 increases in the linear section SS, the likelihood of damage or deformation of the flexible display 230 and/or the support member 240 due to external impacts such as, for example, drops may be reduced.

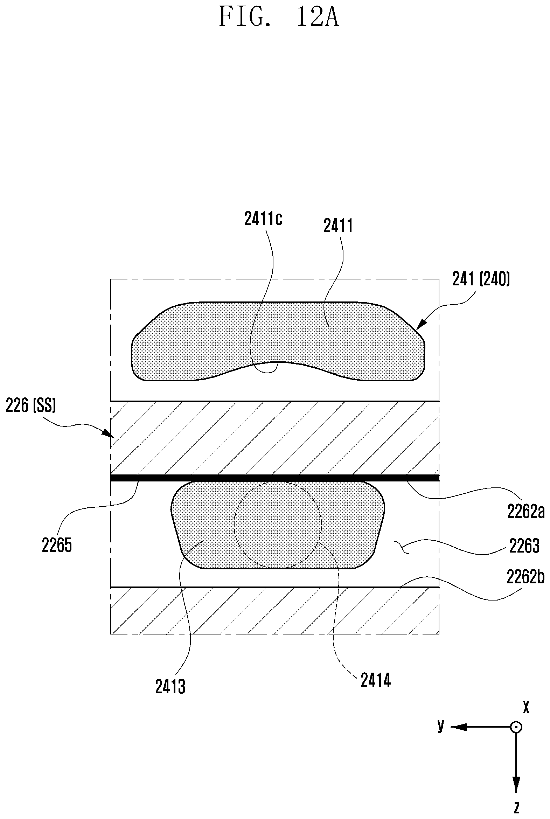

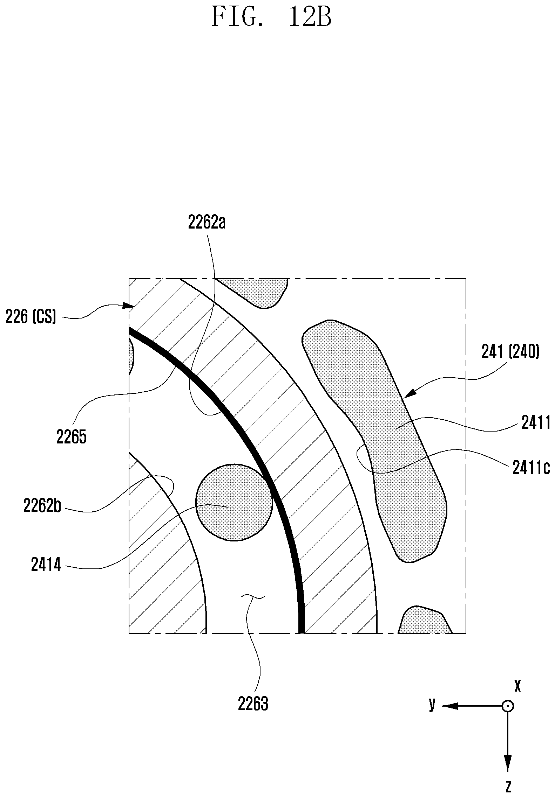

FIG. 12A is a cross-sectional view illustrating the coupling structure of a guide rail and a support bar in the linear section, according to various embodiments of the disclosure. FIG. 12B is a cross-sectional view illustrating the coupling structure of a guide rail and a support bar in the curved section, according to various embodiments of the disclosure.

In describing the guiding structure of the support bars 241 through the guide rail 226 in FIGS. 12A and 12B, the same reference numerals are assigned to components that are substantially identical to those in the guiding structure of FIG. 10D, and detailed descriptions thereof may be omitted.

Referring to FIGS. 12A and 12B, a friction-reducing member 2265 may be disposed between the first guide protrusion 2413 and the first inner surface 2262a of the first guide slit 2263 and/or between the second guide protrusion 2414 and the first inner surface 2262a of the first guide slit 2263. In an embodiment, the friction-reducing member 2265 may help smooth guiding operation by reducing friction between the guide protrusions 2413 and 2414 of the support bar 241 and the first inner surface 2262a of the first guide slit 2263. In an embodiment, the friction-reducing member 2265 may include a Teflon coating layer or a hard coating layer formed on the first inner surface 2262a of the first guide slit 2263 and/or on corresponding contact surfaces of the first guide protrusion 2413 and the second guide protrusion 2414 that are in contact with the first inner surface 2262a. In an embodiment, the friction-reducing member 2265 may be disposed on the first inner surface 2262a of the first guide slit 2263 in the linear section SS. In an embodiment, the friction-reducing member 2265 may be disposed on the first inner surface 2262a of the first guide slit 2263 in the curved section CS. In some embodiments, the friction-reducing member 2265 may be replaced with a sweeper for preventing inflow of foreign substances and/or a buffering member (e.g., sponge, silicone, or rubber) for shock absorption. In some embodiments, the sweeper and/or the buffering member may be disposed together with the friction-reducing member 2265, or a material capable of providing both functions may be applied.

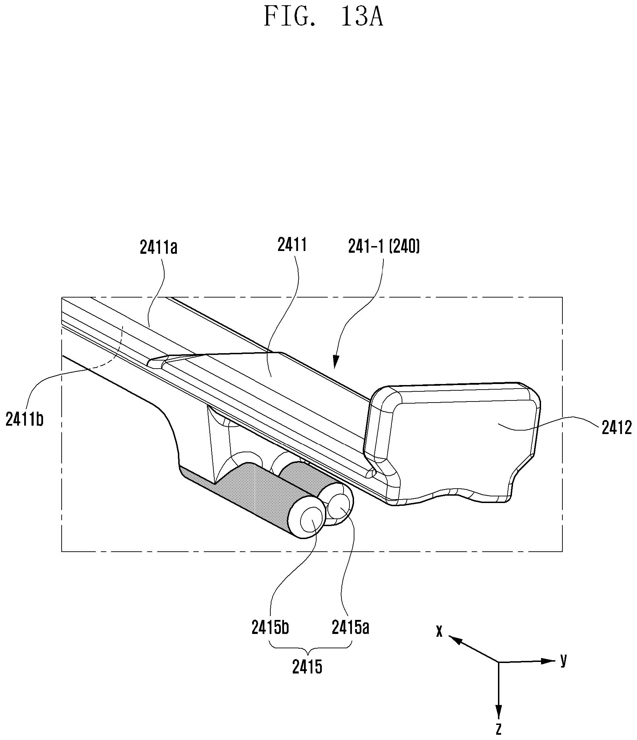

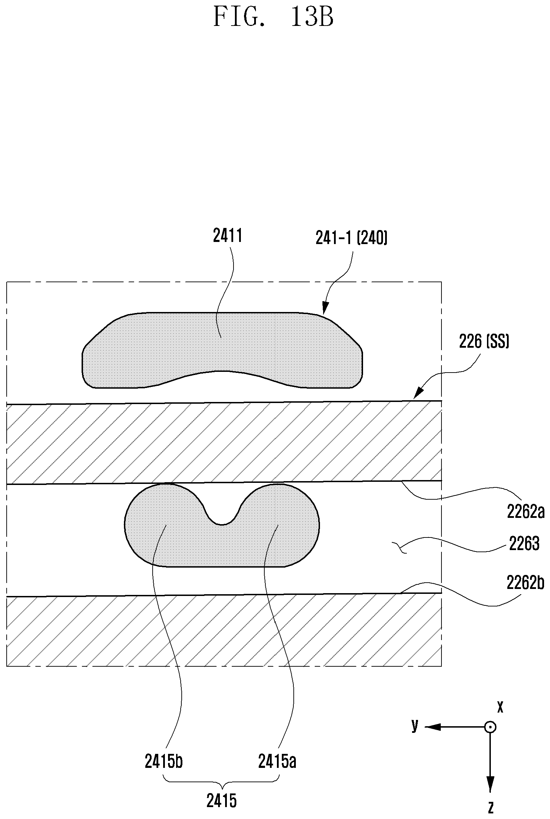

FIG. 13A is a partial perspective view of a support bar according to various embodiments of the disclosure. FIG. 13B is a cross-sectional view illustrating a coupling structure of the support bar of FIG. 13A and a guide rail, according to various embodiments of the disclosure.

In describing the support bar 241-1 in FIGS. 13A and the guiding structure through the support bars 241-1 in FIG. 13B, the same reference numerals are assigned to components that are substantially identical to those in the support bar 241 in FIG. 6A and the guiding structures of the support bars 241 in FIG. 10D, and detailed descriptions thereof may be omitted.

Referring to FIGS. 13A and 13B, the support bar 241-1 may include a support portion 2411 extending in a direction (e.g., the -x-axis direction) perpendicular to the sliding direction of the second housing (e.g., the second housing 220 in FIG. 4A) (e.g., the y-axis direction in FIG. 4A), and a head portion 2412 which is provided at an end of the support portion 2411 and supports an edge of the flexible display 230. In an embodiment, the support portion 2411 may include a first surface 2411a which supports the rear surface of the flexible display 230 and a second surface 2411b facing away from the first surface 2411a. For example, a plane of the first surface 2411a may be angled away from and intersect a plane of the second surface 2411b. In an embodiment, the support bar 241-1 may include a guide protrusion 2415 extending from the second surface 2411b in a direction parallel to the length direction of the support portion 2411 (e.g., the -x-axis direction). In an embodiment, the guide protrusion 2415 may include a first guide protrusion 2415a extending to have a first length and a second guide protrusion 2415b extending from one side of the first guide protrusion 2415a in the same direction as the first guide protrusion 2415a to have a second length longer than the first length.

According to various embodiments, when the guide protrusion 2415 is accommodated in the first guide slit 2263 of the guide rail 226 in the linear section SS, both the first guide protrusion 2415a and the second guide protrusion 2415b may be in contact with the first inner surface 2262a of the first guide slit 2263, thereby expanding the contact area (e.g., surface contact). Although not illustrated, in the curved section (e.g., the curved section CS in FIG. 10D) of the guide slit (e.g., the guide slit 2262 of FIG. 10C), the second guide protrusion 2415b of the support bar 241-1 (and not the first guide protrusion 2415a) may be guided by the first guide slit 2263, thereby helping induce a smooth guiding operation by reducing the contact area (e.g., line contact) with the first inner surface 2262a.

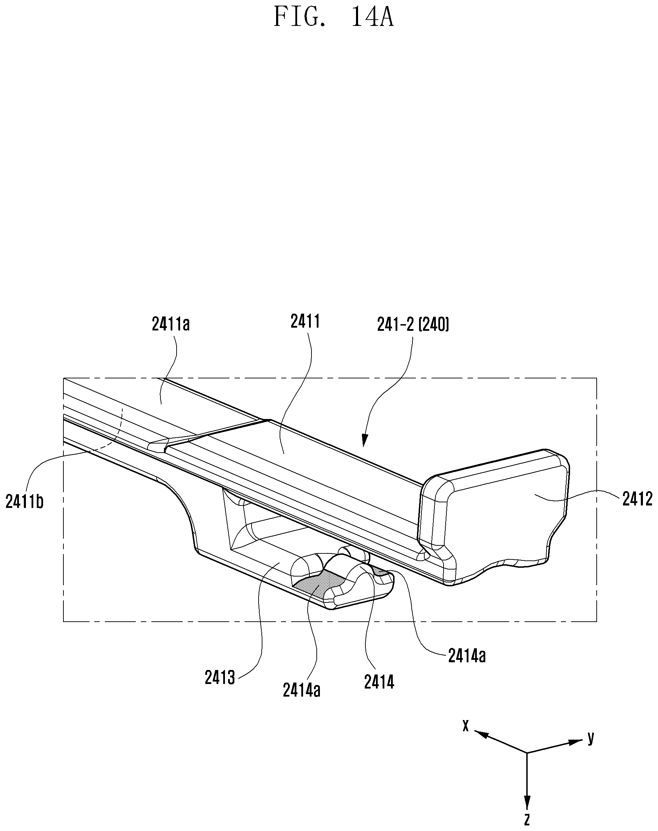

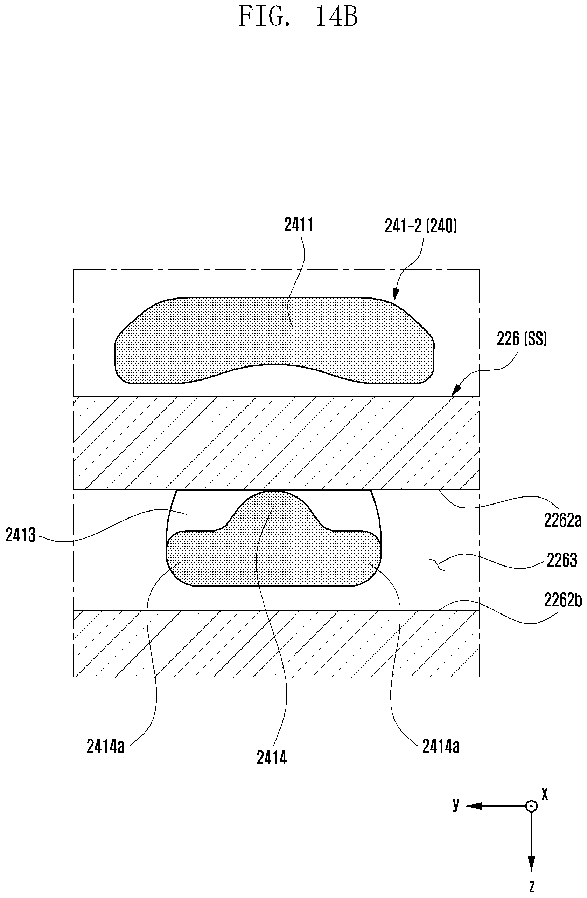

FIG. 14A is a partial perspective view of a support bar according to various embodiments of the disclosure. FIG. 14B is a cross-sectional view illustrating a coupling structure of the support bars of FIG. 14A and a guide rail, according to various embodiments of the disclosure.

In describing the support bar 241-2 in FIG. 14A and the guiding structure through the support bars 241-2 in FIG. 14B, the same reference numerals are assigned to components that are substantially identical to those in the guiding structures of the support bar 241 in FIG. 6A and the support bar 241 in FIG. 10D, and detailed descriptions thereof may be omitted.

Referring to FIGS. 14A and 14B, the support bar 241-2 may include a first guide protrusion 2413 extending from the second surface 2411b of the support portion 2411 and a second guide protrusion 2414 extending from the first guide protrusion 2413. In an embodiment, the second guide protrusion 2414, which is configured to have a relatively smaller contact area than the first guide protrusion 2413 with respect to the first inner surface 2262a of the first guide slit 2263, may be weak in rigidity. According to an example embodiment of the disclosure, the support bar 241-2 may include at least one rigid rib 2414a extending outward from the second guide protrusion 2414. In an embodiment, the at least one rigid rib 2414a may be configured to have a thickness that prevents the at least one rigid rib from coming into contact with the first inner surface 2262a of the first guide slit 2263 in the linear section SS. In an embodiment, the at least one rigid rib 2414a may be configured to have a thickness that prevents the at least one rigid rib from interfering with the guiding operation through the first guide slit 2263 in the curved section (e.g., the curved section CS in FIG. 10D).

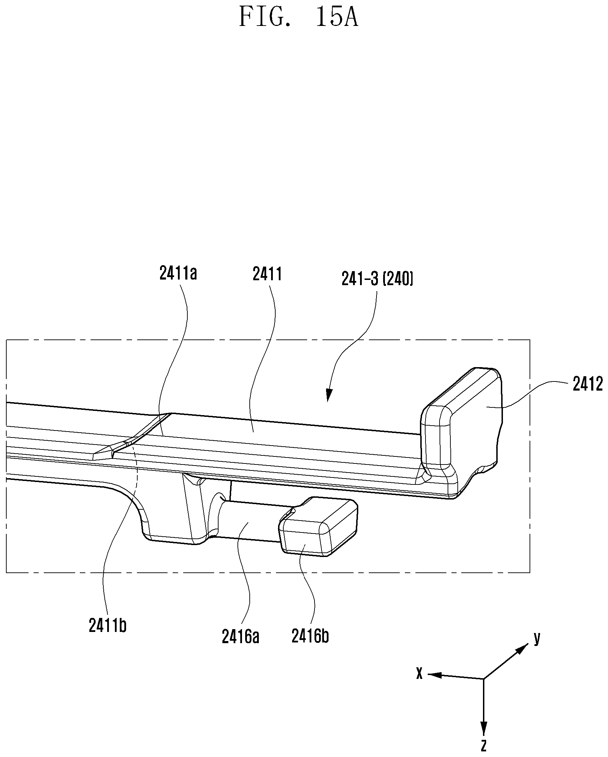

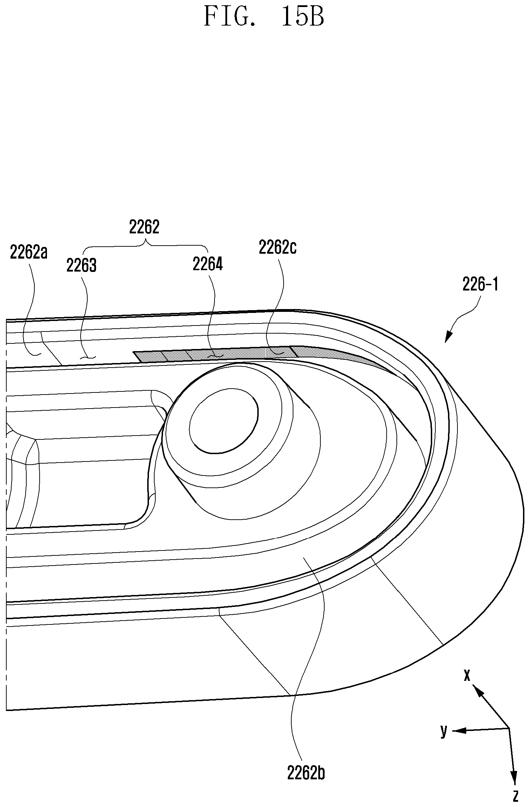

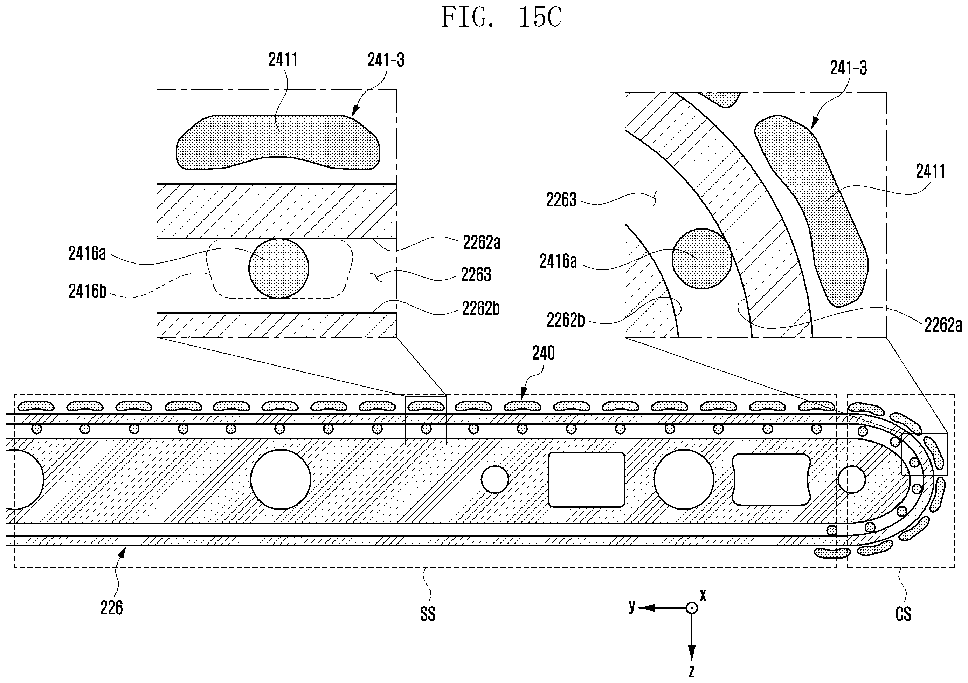

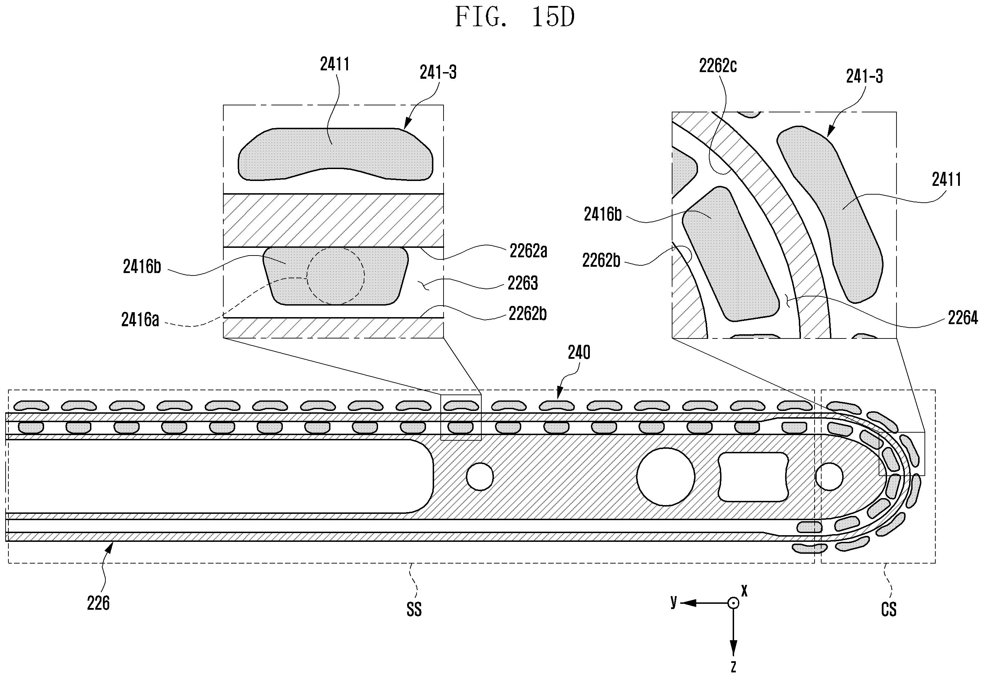

FIG. 15A is a partial perspective view of a support bar according to various embodiments of the disclosure. FIG. 15B is a partial perspective view of a guide rail according to various embodiments of the disclosure. FIG. 15C is a cross-sectional view of the guide rail illustrating a guiding structure of first guide protrusions and a guide slit according to various embodiments of the disclosure. FIG. 15D is a cross-sectional view of the guide rail illustrating a guiding structure of second guide protrusions and a guide slit according to various embodiments of the disclosure.

In describing the support bar 241-3 in FIG. 15A, the guide rail 226-1 in FIG. 15B, and a guiding structure of guide rails 226-1 through support bars in FIGS. 15C and 15D, the same reference numerals are assigned to components that are substantially identical to those in the support bar 241 in FIG. 6A, the guide rail 226 in FIG. 7C, and the guiding structure of the guide rail 226 through the support bars 241 in FIGS. 10D and 10E, and detailed descriptions thereof may be omitted.

Referring to FIGS. 15A to 15D, the support bar 241-3 may include a support portion 2411 extending in a direction (e.g., the -x-axis direction) perpendicular to the sliding direction of the second housing (e.g., the second housing 220 in FIG. 4A) (e.g., the y-axis direction in FIG. 4A), and a head portion 2412 which is provided at an end of the support portion 2411 and supports an edge of the flexible display 230. In an embodiment, the support portion 2411 may include a first surface 2411a which supports the rear surface of the flexible display 230 and a second surface 2411b facing away from the first surface 2411a. In an embodiment, the support bar 241-3 may include a first guide protrusion 2416a extending from the second surface 2411b in a direction parallel to the longitudinal direction of the support portion 2411 (e.g., the - x-axis direction) and a second guide protrusion 2416b extending from the first guide protrusion 2416a.

The guide rail 2261-1 may extend from the linear section SS to the curved section CS and may include a first guide slit 2263, which is formed through a space between a first inner surface 2262a and a second inner surface 2262b, and a second guide slit 2264, which is formed through a space between the second inner surface 2262b and a third inner surface 2262c. The third inner surface 2262c is positioned lower than the first inner surface 2262a (e.g., formed by material removal) of the first guide slit 2263 in the curved section CS.

According to various embodiments, in the linear section SS of the guide slit 2262, the second guide protrusion 2416b may be in contact with the first inner surface 2262a of the first guide slit 2263, thereby expanding the contact area (e.g., surface contact). In this case, the first guide protrusion 2416a may also be in contact with the first inner surface 2262a. In an embodiment, in the curved section CS of the guide slit 2262, since the first guide protrusion 2416a (and not the second guide protrusion 2416b) is guided by the first guide slit 2263, the support bar 241-1 may help induce smooth guiding operation by reducing the contact area (e.g., line contact) with the first inner surface 2262a. In this case, in the curved section CS, the second guide protrusion 2416b may be accommodated in the second guide slit 2264 but may be configured to not come into contact with the second inner surface 2262b and the third inner surface 2262c, thereby preventing interference with the movement of the support bar 241-3.

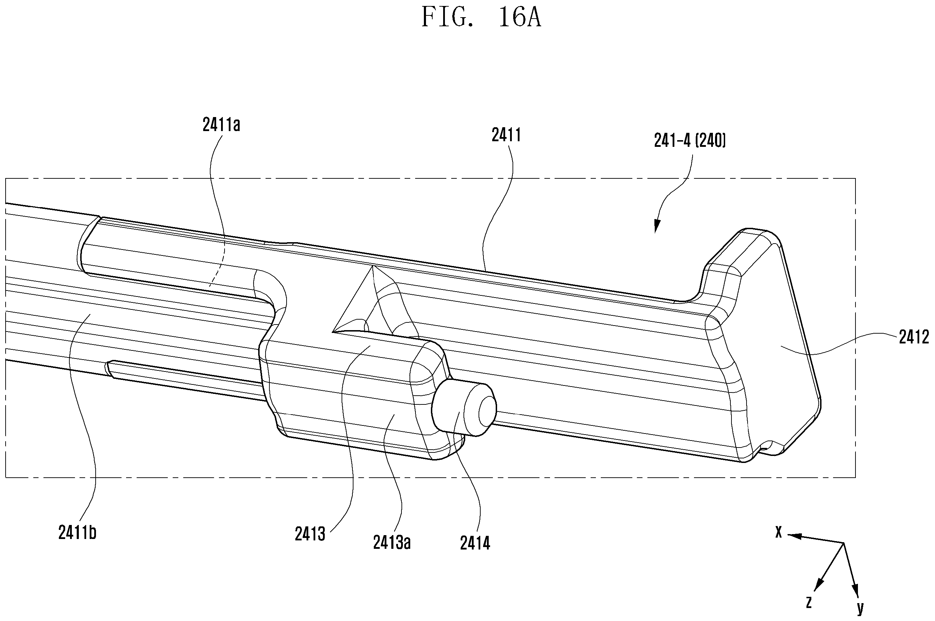

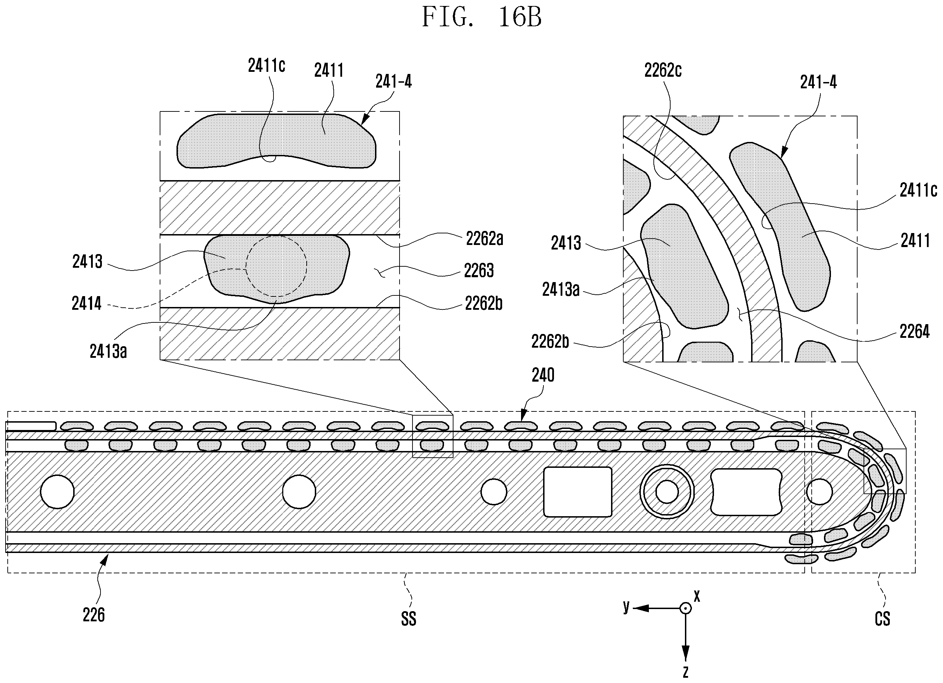

FIG. 16A is a partial perspective view of a support bar according to various embodiments of the disclosure. FIG. 16B is a cross-sectional view illustrating a coupling structure of the support bars in FIG. 16A and a guide rail, according to various embodiments of the disclosure.

In describing the support bar 241-4 in FIGS. 16A and the guiding structure through the support bars 241-4 in 16B, the same reference numerals are assigned to components that are substantially identical to those in the support bar 241 in FIG. 6A and the guiding structure through the support bars 241 in FIG. 10D, and detailed descriptions thereof may be omitted.

Referring to FIGS. 16A and 16B, the support bar 241-4 may include a first guide protrusion 2413 extending from the second surface 2411b of the support portion 2411 and a second guide protrusion 2414 extending from the first guide protrusion 2413. In an embodiment, the support bar 241-4 may include a projection 2413a protruding from the first guide protrusion 2413. In an embodiment, the projection 2413a may protrude from the first guide protrusion 2413 in a direction toward the second inner surface 2262b of the first guide slit 2263. In an embodiment, the projection 2413a may be formed in a shape having the same length as the length of the first guide protrusion 2413. In an embodiment, the portion of the projection 2413a that comes into contact with the second inner surface 2262b may be formed in a curved shape to reduce friction. In some embodiments, a friction-reducing member (e.g., the friction-reducing member 2265 in FIG. 12A) may be disposed between the projection 2413a and the second inner surface 2262b. In some embodiments, the projection 2413a may extend to at least a portion of the second guide protrusion 2414 or may be additionally formed as a separate structure.

According to various embodiments, when the first guide protrusion 2413 and the second guide protrusion 2414 of the support bar 241-4 are accommodated in the first guide slit 2263, the upper surface of the first guide protrusion 2413 may be in contact with the first inner surface 2262a of the first guide slit 2263 in the linear section SS, and the projection 2413a may be in contact with the second inner surface 2262b. In some embodiments, the projection 2413a may be formed to be close to the second inner surface 2262b. Through this arrangement of the projection 2413a, the gap between the first guide protrusion 2413 and the second inner surface 2262b may be eliminated or reduced during the guiding operation, thereby helping reduce the likelihood of damage or deformation of the flexible display 230 and/or the support bar 241-4 due to external impacts such as, for example, drops. In an embodiment, the projection 2413a may be configured to have an amount of protrusion that prevents the projection from coming into contact with the second inner surface 2262b and/or the third inner surface 2262c of the second guide slit 2264 to induce smooth guiding operation in the curved section CS of the guide slit 2262.

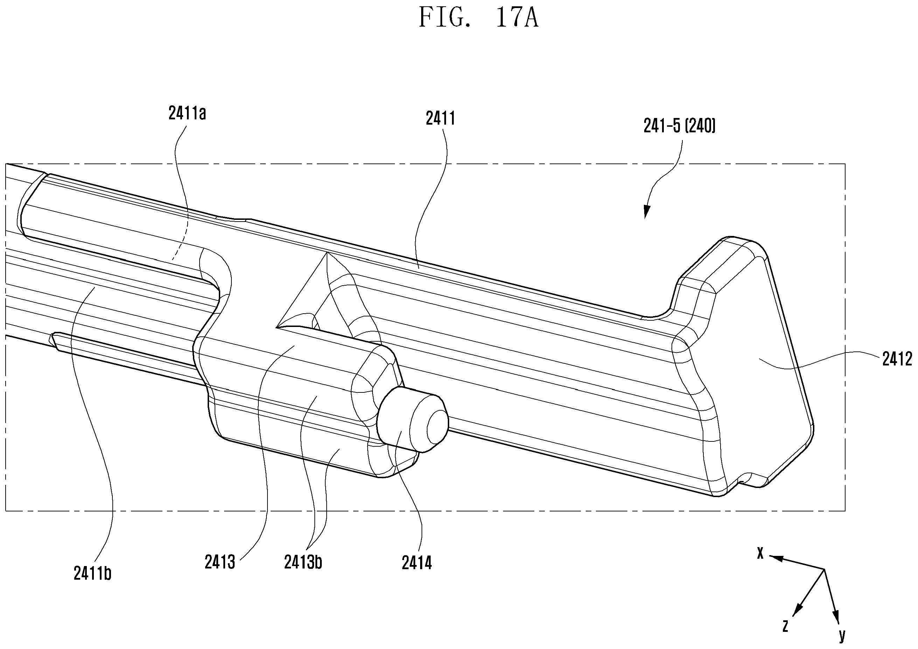

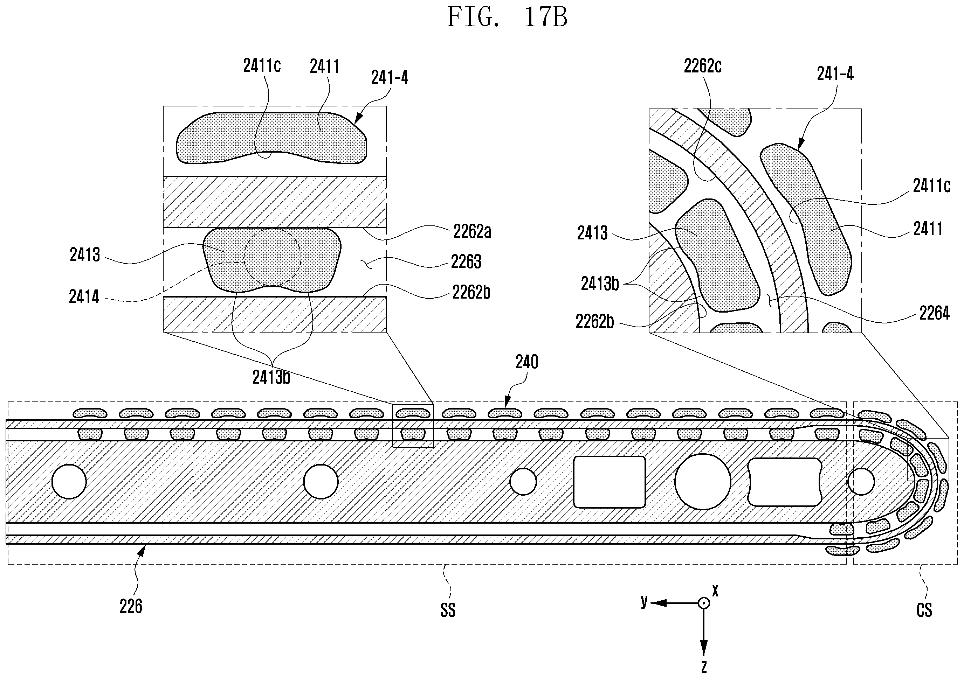

FIG. 17A is a partial perspective view of a support bar according to various embodiments of the disclosure. FIG. 17B is a cross-sectional view illustrating a coupling structure of the support bars in FIG. 17A and a guide rail, according to various embodiments of the disclosure.

In describing the support bar 241-5 in FIGS. 17A and the guide structure through the support bars 241-5 in 17B, the same reference numerals are assigned to components that are substantially identical to those of the support bar 241-4 in FIG. 16A and the guiding structure through the support bars 241-4 in FIG. 16B, and detailed descriptions thereof may be omitted.

Referring to FIGS. 17A and 17B, a support bar 241-5 may include a pair of projections 2413b protruding from the first guide protrusion 2413 at a predetermined interval. In this case, in the linear section SS, the pair of projections 2413b may be in contact with or close to the second inner surface 2262b. As a result, the gap between the first guide protrusion 2413 and the second inner surface 2262b may be eliminated or reduced during the guiding operation, thereby helping reduce the likelihood of damage or deformation of the flexible display 230 and/or the support bar 241-5 due to external impacts such as, for example, drops.

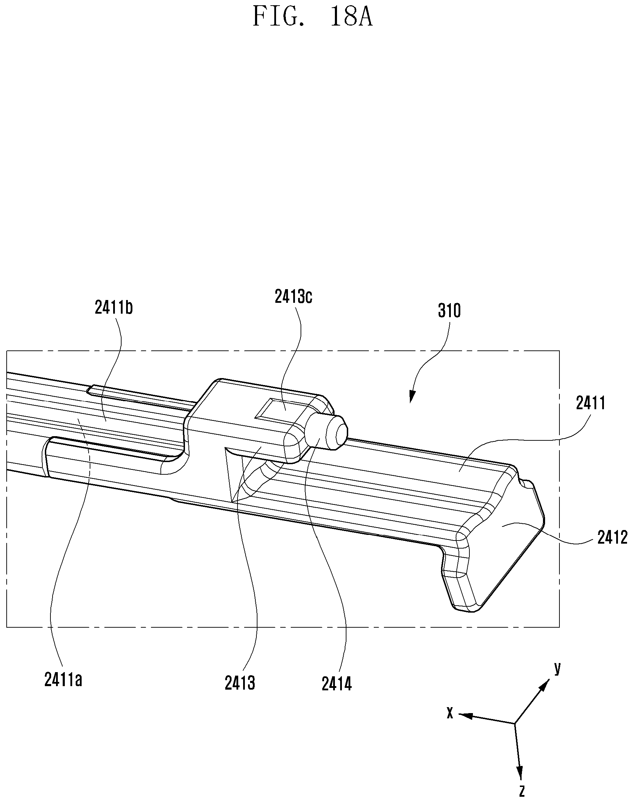

FIGS. 18A to 18D are partial perspective views of support bars according to various embodiments of the disclosure.

In describing the support bars 310, 320, 330, and 340 in FIGS. 18A through 18D, the same reference numerals are assigned to components that are substantially identical to those of the support bar 241-5 in FIG. 16A, and detailed descriptions thereof may be omitted.

Referring to FIG. 18A, the support bar 310 may include a first guide protrusion 2413 extending from the second surface 2411b of the support portion 2411 and a second guide protrusion 2414 extending from the first guide protrusion 2413. In an embodiment, the support bar 310 may include a projection 2413c formed to protrude from the first guide protrusion 2413. In an embodiment, the projection 2413a may protrude from the first guide protrusion 2413 in a direction toward the second inner surface 2262b of the first guide slit 2263. In an embodiment, the projection 2413c may be formed in a rectangular shape at a predetermined position on the rear surface of the first guide protrusion 2413.

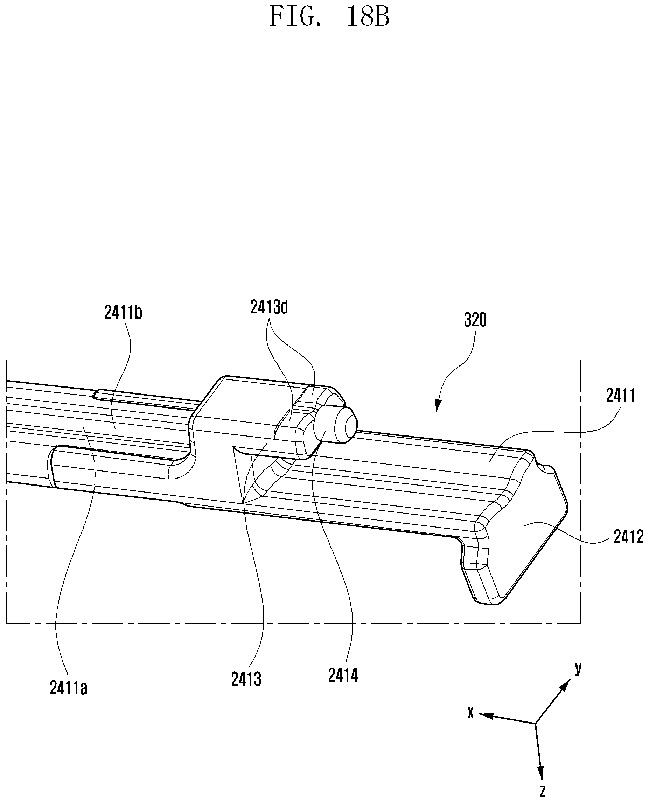

Referring to FIG. 18B, a projection 2413d may be formed as a pair of rectangular shapes in a manner similar to the projection 2413c of FIG. 18A.

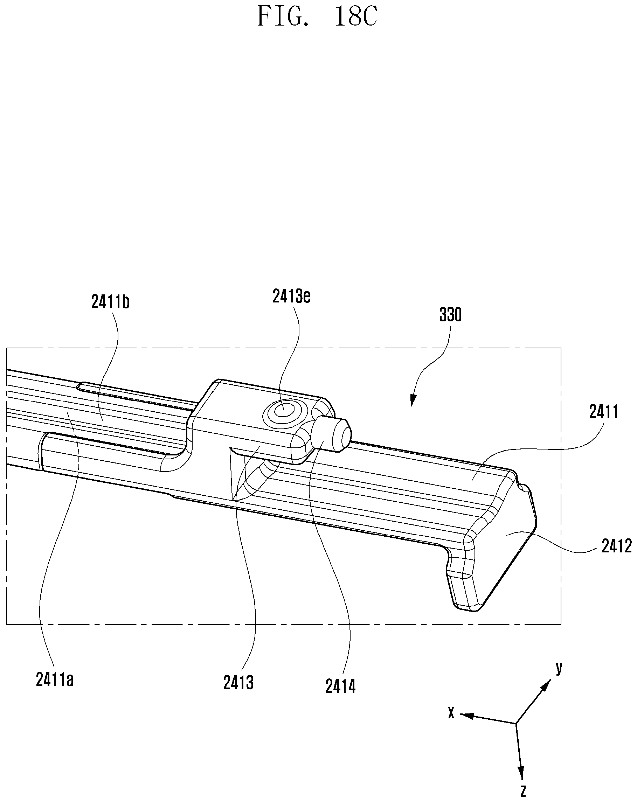

Referring to FIG. 18C, a projection 2413e may be formed in a circular shape in a manner similar to the projection 2413c of FIG. 18A.

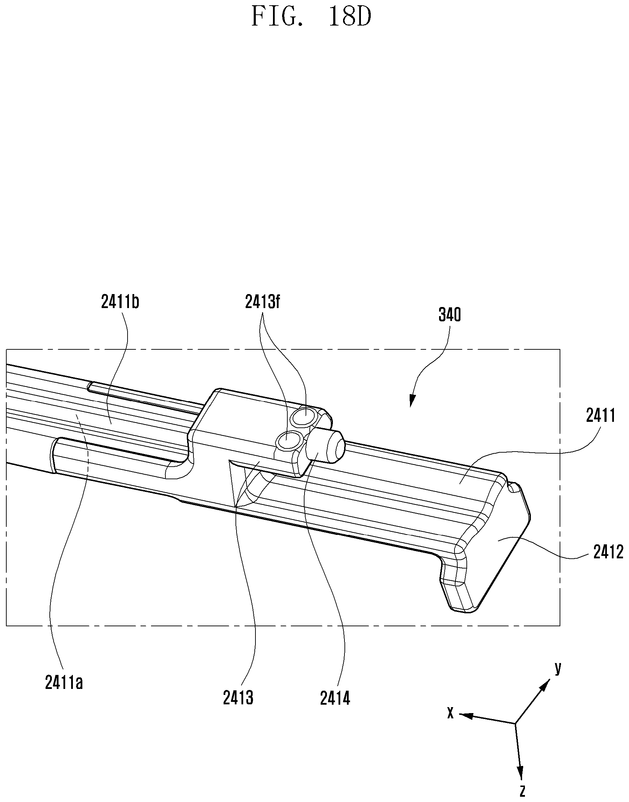

Referring to FIG. 18D, a projection 2413f may be formed as a pair of circular shapes in a manner similar to the projection 2413e of FIG. 18C.

For example, in addition to the illustrated embodiments, the projections may be formed in various shapes such as, for example, elliptical or polygonal shapes and/or may be formed in three or more in number.

According to various embodiments, an electronic device (e.g., the electronic device 200 in FIG. 2A) may include a flexible display (e.g., the flexible display 230 in FIG. 2A), a first housing (e.g., the first housing 210 in FIG. 2A), a second housing (e.g., the second housing 220 in FIG. 2A) movably coupled to the first housing, and a support member (e.g., the support member 240 in FIG. 10A) which supports at least a portion of the flexible display and moves according to movement of the second housing. The support member may include multiple support bars (e.g., the support bars 241 in FIG. 10B) disposed and arranged such that the support bars support the rear surface of the flexible display, first guide protrusions (e.g., the first guide protrusions 2413 in FIG. 10D) respectively protruding from both ends of each of the multiple support bars, and second guide protrusions (e.g., the second guide protrusions 2414 in FIG. 10D) respectively extending from the first guide protrusions. The electronic device may include a guide rail (e.g., the guide rail 226 in FIG. 10D) disposed in the first housing and including a guide slit (e.g., the guide slit 2262 in FIG. 10C) including a linear section (e.g., the linear section SS in FIG. 10D) and a curved section (e.g., the curved section CS in FIG. 10D) extending from the linear section. The guide slit may include a first guide slit (e.g., the first guide slit 2263 in FIG. 10D) extending from the linear section to the curved section and a second guide slit (e.g., the second guide slit 2264 in FIG. 10D) provided in the curved section. In the linear section, among the first guide protrusions and the second guide protrusions, at least the first guide protrusions may be guided through the first guide slit. In the curved section, among the first guide protrusions and the second guide protrusions, the second guide protrusions (i.e., not the first guide protrusions) may be guided through the first guide slit.

According to various embodiments, in the curved section, the first guide protrusions do not come into contact with an inner surface of the second guide slit.

According to various embodiments, in the linear section, a contact area between the first guide protrusions and an inner surface of the guide slit may be greater than a contact area between the second guide protrusions and the inner surface of the guide slit.

According to various embodiments, a friction-reducing member (e.g., the friction-reducing member 2265 in FIG. 12A) may be disposed between the first guide protrusions and an inner surface of the first guide slit and/or between the second guide protrusions and an inner surface of the first guide slit.

According to various embodiments, the friction-reducing member may include a Teflon coating layer or a hard coating layer provided on an inner surface of the guide slit, contact surfaces of the first guide protrusions which are in contact with the inner surface, and/or contact surfaces of the second guide protrusions which are in contact with the inner surface.

According to various embodiments, a boundary area between the linear section and the curved section may include an inclined surface (e.g., the inclined surface 2262d in FIG. 7C) connecting an inner surface of the first guide slit and an inner surface of the second guide slit.

According to various embodiments, the guide slit may include an inner surface, in which the inner surface includes a first inner surface (e.g., the first inner surface 2262a in FIG. 7C) facing in a direction toward the flexible display and extending from the linear section toward the curved section, a second inner surface (e.g., the second inner surface 2262b in FIG. 7C) facing in a direction opposite to the first inner surface and extending from the linear section toward the curved section, and a third inner surface (e.g., the third inner surface 2262c in FIG. 7C) extending from a portion of the first inner surface in the curved section. In the linear section, the first guide protrusions and the second guide protrusions may move while being in contact with the first inner surface, and in the curved section, the second guide protrusions (and not the first guide protrusions) may move while being in contact with the first inner surface.

According to various embodiments, in the linear section, a contact area between the first guide protrusions and the first inner surface may be greater than a contact area between the second guide protrusions and the first inner surface.

According to various embodiments, the third inner surface may be lower than the first inner surface.

According to various embodiments, the first guide slit may be provided or formed through a space between the first inner surface and the second inner surface.

According to various embodiments, the second guide slit may be provided or formed through a space between the second inner surface and the third inner surface.

According to various embodiments, the first guide protrusions and/or the second guide protrusions may include at least one protrusion (e.g., the projection 2413a of FIG. 16A) which is adjacent to or in contact with the second inner surface.

According to various embodiments, the second guide protrusions may extend from the first guide protrusions in a direction parallel to a longitudinal direction of the support bars and protrude further than the first guide protrusions.

According to various embodiments, the electronic device may further include at least one rigid rib (e.g., the rigid rib 2414a of FIG. 14A) extending outward from each of the second guide protrusions. The at least one rigid rib may be configured to have a thickness that prevents the at least one rigid rib from being in contact with an inner surface of the first guide slit in the linear section.

According to various embodiments, each of the multiple support bars may include a support portion (e.g., the support portion 2411 of FIG. 6A) including a first surface (e.g., the first surface 2411a in FIG. 6A) supporting a rear surface of the flexible display and a second surface (e.g., the second surface 2411b in FIG. 6A) facing away from the first surface, and head portions (e.g., the head portions 2412 in FIG. 6A) respectively protruding from both ends of the support portion and supporting edges of the flexible display. The first guide protrusions and the second guide protrusions may protrude from the second surface.

According to various embodiments, the first guide protrusions and the second guide protrusions may each extend from the second surface in a direction parallel to a longitudinal direction of the support portion.

According to various embodiments, the second guide protrusions may be configured to extend from the first guide protrusions in a direction parallel to the longitudinal direction of the support bars.

According to various embodiments, the first guide protrusions and the second guide protrusions may be extend from the second surface to have different lengths.

According to various embodiments, the first guide protrusions and the second guide protrusions may be positioned at least to overlap the support portion when viewed from above the first surface.

According to various embodiments, the head portion may be disposed higher than the first surface from an end portion of the support portion.

The embodiments of the disclosure disclosed in this specification and drawings are provided to propose specific examples in order to easily describe the technical features according to the embodiments of the disclosure and to help understanding of the embodiments of the disclosure, and are not intended to limit the scope of the embodiments of the disclosure. Accordingly, the scope of various embodiments of the disclosure is to be construed as including all changes or modifications derived based on the technical idea of the various embodiments of the disclosure in addition to the embodiments disclosed herein.

## Claims

1. An electronic device (200) comprising:
a flexible display (230);
a first housing (210);
a second housing (220) movably coupled to the first housing (210); and
a support member (240) which supports at least a portion of the flexible display (230) and moves in accordance with movement of the second housing (220),
wherein:
the support member comprises:
support bars (241) supporting a rear surface of the flexible display (230);
first guide protrusions (2413) respectively protruding from both ends of each of the support bars (241); and
second guide protrusions (2414) respectively extending from the first guide protrusions (2413),
the electronic device comprises a guide rail (226) disposed in the first housing (210), the guide rail (226) comprising a guide slit (2262),
the guide slit (2262) comprises:
a linear section (SS);
a curved section (CS) extending from the linear section (SS);
a first guide slit (2263) extending from the linear section (SS) toward the curved section (CS); and
a second guide slit (2264) formed in the curved section (CS), and
wherein, among the first guide protrusions (2413) and the second guide protrusions (2414):
in the linear section (SS), at least the first guide protrusions (2413) are guided through the first guide slit (2263), and in the curved section (CS), the second guide protrusions (2414) are guided through the first guide slit (2263).

2. The electronic device of claim 1, wherein, in the curved section (CS), the first guide protrusions (2413) do not come into contact with an inner surface (2262c) of the second guide slit (2264).

3. The electronic device of claim 1, wherein, in the linear section (SS), a contact area between the first guide protrusions (2413) and an inner surface (2262a) of the first guide slit (2263) is greater than a contact area between the second guide protrusions (2414) and the inner surface (2262a) of the first guide slit (2263).

4. The electronic device of claim 1, further comprising a friction-reducing member (2265), wherein the friction-reducing member (2265):
is disposed between the first guide protrusions (2413) and an inner surface (2262a) of the first guide slit (2263);
is disposed between the second guide protrusions (2414) and the inner surface (2262a) of the first guide slit (2263), or
both.

5. The electronic device of claim 4, wherein the friction-reducing member (2265) comprises a Teflon coating layer or a hard coating layer formed on at least one of:
the inner surface (2262a) of the first guide slit (2263);
contact surfaces of the first guide protrusions (2413) which are in contact with the inner surface (2262a); or
the second guide protrusions (2414) which are in contact with the inner surface (2262a).

6. The electronic device of claim 1, wherein a boundary area between the linear section (SS) and the curved section (CS) comprises an inclined surface (2262d) connecting an inner surface (2262a) of the first guide slit (2263) and an inner surface (2262c) of the second guide slit (2264).

7. The electronic device of claim 1, wherein the guide slit (2262) comprises an inner surface, and the inner surface comprises:
a first inner surface (2262a) facing in a direction toward the flexible display (230) and extending from the linear section (SS) toward the curved section (CS);
a second inner surface (2262b) facing in a direction opposite to the first inner surface (2262a) and extending from the linear section (SS) toward the curved section (CS); and
a third inner surface (2262c) extending from a portion of the first inner surface (2262a) in the curved section (CS),
wherein:
in the linear section (SS), the first guide protrusions (2413) and the second guide protrusions (2414) move while being in contact with the first inner surface (2262a), and
among the first guide protrusions (2413) and the second guide protrusions (2414), in the curved section (CS), the second guide protrusions (2414) move while being in contact with the first inner surface (2262a).

8. The electronic device of claim 7, wherein, in the linear section (SS), a contact area between the first guide protrusions (2413) and the first inner surface (2262a) is greater than a contact area between the second guide protrusions (2414) and the first inner surface (2262a).

9. The electronic device of claim 7, wherein the third inner surface (2262c) is lower than the first inner surface (2262a).

10. The electronic device of claim 7, wherein the first guide slit (2263) is formed through a space between the first inner surface (2262a) and the second inner surface (2262b).

11. The electronic device of claim 7, wherein the second guide slit (2264) is formed through a space between the second inner surface (2262b) and the third inner surface (2262c).

12. The electronic device of claim 7, wherein the first guide protrusions (2413), the second guide protrusions (2414), or both comprise at least one protrusion (2413a, 2413b, 2413c, 2413d, 2413e, 2413f) which is adjacent to or in contact with the second inner surface (2262b).

13. The electronic device of claim 1, wherein the second guide protrusions (2414) extend from the first guide protrusions (2413) in a direction parallel to a longitudinal direction of the support bars (241) and protrude further than the first guide protrusions (2413).

14. The electronic device of claim 1, further comprising:
at least one rigid rib (2414a) extending outward from each of the second guide protrusions (2414),
wherein the at least one rigid rib (2414a) has a thickness that prevents the at least one rigid rib from being in contact with an inner surface (2262a) of the first guide slit (2263) in the linear section (SS).

15. The electronic device of claim 1, wherein each of the support bars (241) comprises:
a support portion (2411) comprising a first surface (2411a) supporting the rear surface of the flexible display (230) and a second surface (2411b) facing away from the first surface (2411a); and
head portions (2412) respectively protruding from both ends of the support portion (2411) and supporting edges of the flexible display (230),
wherein the first guide protrusions (2413) and the second guide protrusions (2414) protrude from the second surface (2411b).
